# EUROPEAN PATENT SPECIFICATION

(11) **EP 2 826 827 B1**
(45) Date of publication and mention of the grant of the patent: **12.06.2019**
(21) Application number: 13177123.0
(22) Date of filing: 18.07.2013
(51) Int. Cl.: C09D 7/65, C09G 1/02, H01L 21/321, C09K 3/14, C09D 5/02, H01L 21/306

(54) **CMP composition comprising abrasive particles containing ceria**
CMP-Zusammensetzung mit ceriahaltigen Schleifteilchen
Composition CMP comprenant des particules abrasives à cérium

(43) Date of publication of application: 21.01.2015
(73) Proprietor: BASF SE, 67056 Ludwigshafen am Rhein (DE)
(72) Inventor: Lauter, Michael, 68163 Mannheim (DE); Li, Yuzhuo, "Verstorben" (DE); Noller, Bastian Marten, 67141 Neuhofen (DE); Lange, Roland, 67117 Limburgerhof (DE); Reichardt, Robert, 67071 Ludwigshafen am Rhein (DE); Lan, Yongqing, 67071 Ludwigshafen (DE); Boyko, Volodymyr, 68159 Mannheim (DE); Kraus, Alexander, 83132 Pittenhart (DE); von Seyerl, Joachim, 83370 Seeon (DE); Usman Ibrahim, Sheik Ansar, 3001 Heverlee (BE); Siebert, Max, 67063 Ludwigshafen (DE); Hartnagel, Kristine, 64653 Lorsch (DE); Dengler, Joachim, 83342 Tacherting (DE); Hilesheim, Nina Susanne, 63667 Nidda (DE)
(74) Representative: BASF IP Association

(56) References cited:
- EP-A1- 1 796 152
- EP-A1- 2 568 024
- WO-A2-2006/105322
- US-A1- 2007 287 817
- US-A1- 2012 270 399
- M. Piepera, J. Tomas: "Redispersing and Stabilisation of Submicron Agglomerates by Shear Forces", , 5 July 2012 (2012-07-05), XP002717051, DOI: doi:10.3850/978-981-07-2518-1_049 Retrieved from the Internet: URL:http://rpsonline.com.sg/proceedings/97 89810725181/html/049.xml [retrieved on 2013-11-27]

## Description

The present invention relates to a chemical-mechanical polishing (CMP) composition comprising abrasive particles containing ceria, a process for preparing a CMP composition according to the present invention, a process for the manufacture of a semiconductor device comprising chemical mechanical polishing of a substrate in the presence of a chemical mechanical polishing (CMP) composition according to the present invention, to the use of specific polymers for suppressing the agglomeration and/or adjusting the zeta potential of ceria containing particles dispersed in aqueous medium and to a process for suppressing the agglomeration and/or adjusting the zeta potential of ceria containing particles dispersed in aqueous medium.

In the semiconductor industry, chemical mechanical polishing (abbreviated as CMP) is a well-known technology applied in fabricating advanced photonic, microelectromechanical, and microelectronic materials and devices, such as semiconductor wafers.

During the fabrication of materials and devices used in the semiconductor industry, CMP is employed to planarize metal and/or oxide surfaces. CMP utilizes the interplay of chemical and mechanical action to planarize surfaces. Chemical action is provided by a chemical composition, also referred to as a CMP slurry or a CMP composition. Mechanical action is usually carried out by a polishing pad which is typically pressed onto the to-be-polished surface and mounted on a moving platen, and by abrasive particles which are dispersed in the CMP composition. The movement of the platen is usually linear, rotational or orbital. In a typical CMP process step, a rotating wafer holder brings the to-be-polished substrate in contact with a polishing pad. The CMP composition is usually applied between the substrate's surface to-be-polished and the polishing pad.

Particularly in the fabrication of integrated circuits and microelectromechanical devices, very high requirements have to be met for the CMP process step, which is carried out at each level of a multileveled structure. One important parameter describing these requirements is the material removal rate (MRR) i.e. the speed with which the to-be-polished material is removed.

The CMP compositions typically used in this field contain particles of inorganic materials, which serve as abrasives, and various further components. For certain CMP applications, colloidal ceria containing particles are used as abrasive. Ceria-based CMP compositions have received considerable attention in STI (shallow trench isolation) applications because of their ability to achieve a comparatively high oxide-to-nitride selectivity due to the high chemical affinity of ceria to silicon dioxide which is also referred to in the art as the chemical tooth action of ceria.

The stability of a dispersed colloid is determined by the zeta-potential of the colloid particles. The zeta potential of a particle is the potential at the plane where shear with respect to the bulk solution is postulated to occur. This plane, named shear plane, is located in the diffuse part of the electrical double layer and is interpreted as a sharp boundary between the hydrodynamically mobile and the immobile fluid (see Measurement and Interpretation of Electrokinetic Phenomena by A. V. Delgado et al., Journal of Colloid and Interface Science 309 (2007), p. 194-224). As an indicator for the colloid stability of a dispersion, the zeta potential can be considered as an estimation for the surface charge of a particle and depends on the composition and pH, temperature, ionic strength, and ionic species in the liquid.

Within a colloid comprising only one sort of particles, e.g. particles of ceria, at a given set of conditions (pH, temperature, ionic strength, and ionic species in the liquid) the zeta potential of all particles has the same sign. Thus, when the particles carry significant charges, electrostatic repulsion prevents them from coagulation (flocculation).

For colloidal oxides, the zeta potential strongly depends on the pH of the liquid. At a pH in the acidic region, the particles of a colloidal oxide usually have H⁺ ions adsorbed on their surfaces. When the pH is increased, the adsorbed H⁺ ions are neutralized, resulting in a decrease of the surface charge until the isoelectric point is reached where the overall charge of each colloid oxide particle is zero. Accordingly, the electrostatic repulsion between particles ceases, so that the particles can coagulate into larger particles (agglomerated particles) due to the action of Van der Waals forces. For colloidal ceria, in the absence of stabilizing additives, the zeta potential is significantly above 30 mV at a pH of 5.5 or lower, but significantly decreases when the pH rises above 6, resulting in coagulation of the particles.

Another issue is that in the case of dielectric substrates the surface of the substrate to be polished by the CMP composition is charged, too. If the charge of the substrate to be polished is opposite to the charge of the abrasive particle, due to electrostatic attraction the abrasive particles adsorb on the oppositely charged surface and are hardly removable after polishing. On the other hand, if the charge of the material to be polished is of the same sign like of the abrasive particle, polishing is hindered due to electrostatic repulsion. Accordingly, the material removal rate and selectivity strongly depends on the interaction between the zeta potential of the abrasive and the charge of the material to be polished. For this reason, it is preferred that the abrasive particles carry no significant charge. Unfortunately, reducing the absolute value of the surface charge of the abrasive particles promotes coagulation of said particles for the reasons described above.

In order to at least partially solve the above-explained problems, several additives for CMP compositions have been proposed which shall minimize agglomeration of the abrasive particles and/or improve the material removal rate and selectivity of the respective CMP composition.

In EP 1 844 122 B1 an adjuvant for use in simultaneous polishing of a cationically charged material like silicon nitride and an anionically charged material like silicon dioxide is disclosed. It is assumed that said adjuvant forms an adsorption layer on the cationically charged material in order to increase the polishing selectivity of the anionically charged material over the cationically charged material. The adjuvant comprises a polyelectrolyte salt containing: (a) a graft type polyelectrolyte that has a weight average molecular weight of 1,000 to 20,000 and comprises a backbone and a side chain having a specific structure as defined in EP 1 844 122 B1; and (b) a basic material. Said adjuvant shall also minimize agglomeration of abrasive particles. However, the examples of EP 1 844 122 B1 show that said objects are not always achieved with the proposed adjuvants. In some cases the material removal selectivity of silicon dioxide over silicon nitride is not increased, compared to CMP compositions with prior art adjuvants. Furthermore, in the CMP compositions comprising an adjuvant according to EP 1 844 122 B1 the average agglomerated particle size of the ceria particles is higher than 500 nm which is not acceptable for a plurality of CMP applications. The influence of said adjuvant on the zeta potential of the ceria particles is not discussed in EP 1 844 122 B1.

WO 2006/105322 A2 discloses colloidal dispersion of mineral particles, such as ceria, stabilized with a phosphonate terminated poly(oxyalkene) polymer. US 2012/0270399 A1 discloses CMP slurry composition comprising an abrasive particle; a dispersant; an ionic polymer additive; and a non-ionic polymer additive including a polyolefin-polyethylene glycol copolymer including at least two polyethylene glycol repeat unit as a backbone and at least a polyethylene glycol repeating unit as a side chain. US 2012/0270399 A1 reports excellent polishing selectivity of a silicon oxide layer over a single-crystalline silicon layer or a polysilicon layer.

One of the objects of the present invention is to provide a chemical mechanical polishing (CMP) composition and a CMP process showing an improved polishing performance especially for dieletric substrates. More specifically it is an object of the present invention to provide a chemical mechanical polishing (CMP) composition and a CMP process showing
(i) a high material removal rate (MRR) of silicon dioxide, or
(ii) an adjustable selectivity between silicon dioxide and silicon nitride, or
(iii) an adjustable selectivity between silicon dioxide and polycrystalline silicon,
(iv) a high surface quality of the polished surfaces
(v) preferably the combination of (i), (ii), (iii) and (iv).

It is a further object of the present invention to provide a chemical mechanical polishing (CMP) composition comprising ceria particles wherein agglomeration of the ceria particles at a pH value of 6 and higher, preferably up to a pH value of 10, is suppressed.

It is a further object of the present invention to provide a chemical mechanical polishing (CMP) composition comprising ceria particles wherein the ceria particles carry low charges, i.e. have a low zeta potential.

According to a first aspect of the present invention, a chemical-mechanical polishing (CMP) composition is provided comprising the following components:
(A) abrasive particles containing ceria
(B) one or more polymers, wherein each macromolecule of said polymers (B) comprises
   (i) one or more anionic functional groups
      and
   (ii) one or more structure units -(AO)ₐ-R
      wherein in each structure unit -(AO)ₐ-R independently from each other structure unit -(AO)ₐ-R
      A is CₓH₂ₓ wherein for each A in said structure units -(AO)ₐ-R, x is (independently from each other x) selected from the range of integers from 2 to 4, wherein x is preferably 2 or 3, further preferably x =2
      wherein within each structure unit -(AO)ₐ-R the groups A are the same or different
      a is an integer selected from the range of from 5 to 200, preferably 8 to 150, most preferably 20 to 135,
      R is hydrogen or a branched or linear alkyl group having 1 to 4 carbon atoms,
      wherein in said polymer (B) the sum of the molar masses of all structure units (ii) is at least 50 % of the molar mass of said polymer (B),
wherein said composition has a pH in the range of from 6 to 10 and wherein the concentration of said one or more polymers (B) is in a range of from 0.0002 wt.-% to 0.1 wt.-%; based on the total weight of the respective CMP composition.

Further details, modifications and advantages of the present invention are explained in the following detailed description and the examples.

### (A) Abrasive particles containing ceria

The CMP composition according to the present invention comprises as component (A) abrasive particles containing ceria. In the CMP process, said ceria particles act (A) as an abrasive towards the surface to be polished.

Preferably, the abrasive particles (A) consist of ceria. Preferably, a chemical-mechanical polishing (CMP) composition according to the present invention does not contain other abrasive particles than (A) abrasive particles containing ceria or consisting of ceria.

Within the CMP composition of the present invention, the ceria particles are typically dispersed in a colloidal state.

Suitable ceria containing abrasive particles (A) are commercially available, for instance under the trade name Rhodia.

Suitable ceria containing abrasive particles (A) are obtainable e.g. by a wet precipitation process or by a plasma process. In the later case the ceria is also referred to as fumed ceria. In some cases, wet-precipitated ceria is preferred because of it has very good dispersion properties. In other cases, fumed ceria is preferred because it has a very strong abrasive action.

In a CMP composition according to the present invention, it is preferred that the abrasive particles containing ceria have a particle size distribution characterized by a D₅₀ value of 500 nm lower, preferably of 250 nm or lower, further preferably 200 nm or lower, particularly preferably 180 nm or lower, most preferably 150 nm or lower. The particle size distribution can be measured for example with DLS (dynamic light scattering) or SLS (static light scattering) methods. These and other methods are well known in the art, see e.g. Kuntzsch, Timo; Witnik, Ulrike; Hollatz, Michael Stintz; Ripperger, Siegfried; Characterization of Slurries Used for Chemical-Mechanical Polishing (CMP) in the Semiconductor Industry; Chem. Eng. Technol; 26 (2003), volume 12, page 1235. Typically a Horiba LB550 V (DLS, dynamic light scattering, measurement according to manual) or any other DLS instrument is used. The particle size distribution of a ceria dispersion is usually measured in a plastic cuvette at 0.1 to 1.0 % solid concentration. Dilution, if necessary, is carried out with the dispersion medium or ultra pure water. The D₅₀ value of the volume based particle size distribution is shown as representation of the particle size distribution.

The particle size distribution of the abrasive particles containing ceria (A) can be monomodal, bimodal or multimodal. Preferably, the particle size distribution is monomodal in order to have an easily reproducible property profile of the abrasive particles containing ceria (A) and easily reproducible conditions during the process of the invention.

Moreover, the particle size distribution of the abrasive particles containing ceria (A) can be narrow or broad. Preferably, the particle size distribution is narrow with only small amounts of small particles and large particles in order to have an easily reproducible property profile of the abrasive particles containing ceria (A) and easily reproducible conditions during the process of the invention.

The abrasive particles containing ceria (A) can have various shapes. Thus, they may be of one or essentially one type of shape. However, it also possible that the abrasive particles containing ceria (A) have different shapes. In particular, two types of differently shaped abrasive particles containing ceria (A) may be present in a given composition of the invention. As regards the shapes themselves, they can be cubes, cubes with chamfered edges, octahedrons, icosahedrons, nodules and spheres with or without protrusions or indentations. Most preferably, the shape is spherical with no or only very few protrusions or indentations. This shape, as a rule, is preferred because it usually increases the resistance to the mechanical forces the abrasive particles containing ceria (A) are exposed to during a CMP process.

The abrasive particles (A) which contain ceria can contain minor amounts of other rare earth metal oxides.

The abrasive particles (A) which consist of ceria can have a hexagonal, cubic or face-centered cubic crystal lattice.

In certain specific cases, the abrasive particles (A) which contain ceria are composite particles comprising a core containing or consisting of at least one other abrasive particulate material which is different from ceria, in particular alumina, silica, titania, zirconia, zinc oxide, and mixtures thereof.

Such composite particles are known, for example, from WO 2005/035688 A1, US 6,110,396, US 6,238,469 B1, US 6,645,265 B1, K. S. Choi et al., Mat. Res. Soc. Symp. Proc., Vol. 671, 2001 Materials Research Society, M5.8.1 to M5.8.10, S.-H. Lee et al., J. Mater. Res., Vol. 17, No. 10 (2002), pages 2744 to 2749, A. Jindal et al., Journal of the Electrochemical Society, 150 (5), G314-G318 (2003), Z. Lu, Journal of Materials Research, Vol. 18, No. 10, October 2003, Materials Research Society, or S. Hedge et al., Electrochemical and Solid-State Letters, 7 (12), G316-G318 (2004).

Most preferably, the composite particles are raspberry-type coated particles comprising a core selected from the group consisting of alumina, silica titania, zirconia, zinc oxide, and mixtures thereof with a core size of from 20 to 100 nm wherein the core is coated with ceria particles having a particle size below 10 nm.

Particularly preferred is a chemical-mechanical polishing (CMP) composition according to the present invention, wherein the total amount of (A) abrasive particles containing ceria is in a range of from 0.01 wt.-% to 5 wt.-%, preferably 0.1 wt.-% to 1.0 wt.-%, for example 0.5 wt.-%, in each case based on the total weight of the respective CMP composition.

### (B) Polymers

A CMP composition according to the present invention comprises one or more polymers (B), wherein each macromolecule of said polymers (B) comprises
(i) one or more anionic functional groups
   and
(ii) one or more structure units -(AO)ₐ-R
wherein in each structure unit -(AO)ₐ-R independently from each other structure unit -(AO)ₐ-R
A is CₓH₂ₓ wherein for each A in said structure units -(AO)ₐ-R, x (is independently from each other x) selected from the range of integers from 2 to 4, wherein x is preferably 2 or 3, further preferably x =2
wherein within each structure unit -(AO)ₐ-R the groups A are the same or different a is an integer selected from the range of from 5 to 200, preferably 8 to 150, most preferably 20 to 135,
R is hydrogen or a branched or linear alkyl group having 1 to 4 carbon atoms,
wherein in said polymer (B) the sum of the molar masses of all structure units (ii) is at least 50 % of the molar mass of said polymer (B).

The polymers (B) to be used according to the present invention are water-soluble.

The structure units -(AO)ₐ-R are hereinbelow also referred to as structure units (ii). The group R is preferably selected from the group consisting of hydrogen and methyl.

Anionic functional groups are functional groups which in the dissociated state carry a negative charge. Preferably, in the macromolecules of said polymer (B) or of at least one of said polymers (B) said one or more anionic functional groups are selected from the group consisting of the carboxylic group, the sulfonic group, the sulfate group, the phosphoric group and the phosphonic group.

A carboxylic group has the structure -COOM (wherein M is H or one cation equivalent) in the undissociated state and -COO⁻ in the dissociated state.

A sulfate group has the structure -O-SO₃M (wherein M is H or one cation equivalent) in the undissociated state and -O-SO₃⁻ in the dissociated state.

A sulfonic group has the structure -SO₃M (wherein M is H or one cation equivalent) in the undissociated state and -SO₃⁻ in the dissociated state.

A phosphoric group has the structure -O-PO₃M₂ (wherein M is H or one cation equivalent) in the undissociated state, -O-PO₃M⁻ (wherein M is H or one cation equivalent) in the first dissociated state and -O-PO₃²⁻ in the second dissociated stage.

In the context of the present application, the term phosphoric group includes phosphoric groups wherein one of the two hydroxy groups is esterified by an alcohol R^{x}-OH, resulting in a structure -O-P(OR^{x})O₂M (wherein M is H or one cation equivalent) in the undissociated state, and -O-P(OR)O₂⁻ in the dissociated state.

A phosphonic group has the structure -PO₃M₂ (wherein M is H or one cation equivalent) in the undissociated state, -PO₃M⁻ (wherein M is H or one cation equivalent) in the first dissociated state and -PO₃²⁻ in the fully dissociated stage.

In the context of the present application, the term phosphonic group includes phosphonic groups wherein one of the two hydroxy groups is esterified by an alcohol R^{x}-OH, resulting in a structure -P(OR^{x})O₂M (wherein M is H or one cation equivalent) in the undissociated state and -P(OR^{x})O₂⁻ in the dissociated state.

The structure units -AO- defined above are preferably selected from the group consisting of -O-CH₂-CH₂-, -O-CH₂-CH(CH₃)-, -O-CH(CH₃)-CH₂- and -O-CH₂-CH₂-CH₂-CH₂-, wherein -O-CH₂-CH₂- (a structure unit derived from ethylene oxide) is preferred.

Preferably, in the polymers (B) to be used according to the present invention, the molar mass of each of said one or more structure units (ii) -(AO)ₐ-R is 500 g/mol or more, preferably 1000 g/mol or more, more preferably 2000 g/mol or more, most preferably 3000 g/mol or more
and/or
the sum of the molar masses of all of said structure units (ii) -(AO)ₐ-R is 60 % or more, preferably 70 % or more, most preferably 80 % or more of the molar mass of said polymer (B).

Preferably, said polymer (B) or at least one of said polymers (B) is selected from the group consisting of comb polymers and block copolymers.

Block copolymers are copolymers whose macromolecules each consist of adjacent blocks which are constitutionally different, i.e. the adjacent blocks in each case comprise either constitutional units derived from different species of monomer or from the same species of monomer but with a different composition or sequence distribution of constitutional units.

Comb polymers are polymers whose macromolecules are comb macromolecules each comprising a main chain (typically referred to as the backbone) with a plurality of trifunctional branch points from each of which a linear side-chain emanates. Comb polymers are obtainable by homopolymerisation or copolymerisation of long-chained α-olefines, alkyloxiranes, vinyl ethers, vinyl esters, alkyl(meth)acrylates or *N*-alkyl(meth)acrylamides. The long-chained monomers are also referred to as macromers. Alternatively, they are obtainable by graft copolymerisation.

In preferred CMP composition of the present invention, said polymer (B) or at least one of said polymers (B) is a comb polymer comprising
(i) a backbone to which one or more anionic functional groups are linked
   and
(ii) one or more side chains each comprising or consisting of a structure unit -(AO)ₐ-R (wherein A, a and R have the above-defined meaning)
wherein in said comb polymer the sum of the molar masses of all said structure units (ii) -(AO)ₐ-R is at least 50 % of the molar mass of said comb polymer.

Hereinbelow, specific types of preferred polymers (B) are described in more detail, e.g. by means of general formulae. Insofar as in different general formulae identical variables are used and such variables have different meanings in said respective formulae, in each case the meaning defined specifically for the respective formulae is binding.

A preferred comb polymer (B) comprises
- building units each comprising one or more anionic functional groups
   and
- side chains each comprising a structure unit (ii) -(AO)ₐ-R wherein
   A is CₓH₂ₓ wherein for each A in said structure units -(AO)ₐ-R, x is (independently from each other x) selected from the range of integers from 2 to 4, wherein x is preferably 2 or 3, further preferably x =2
   wherein within each structure unit -(AO)ₐ-R the groups A are the same or different a is an integer selected from the range of from 5 to 200, preferably 8 to 150, most preferably 20 to 135
   R is hydrogen or a branched or linear alkyl group having 1 to 4 carbon atoms,
wherein one or more of the building units comprising an anionic functional group are selected from general formulae (7.1), (7.2), (7.3) and (7.4): 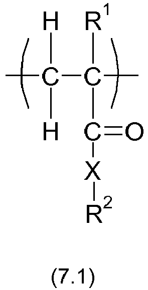 in which
R¹ is H or an unbranched or branched C₁-C₄ alkyl group, CH₂COOH or CH₂CO-X-R²;
R² is PO₃M₂, O-PO₃M₂, (C₆H₄)-PO₃M₂ or (C₆H₄)-OPO₃M₂;
X is NR⁷-(CₙH₂ₙ) or O-(CₙH₂ₙ) with n = 1, 2, 3 or 4, the nitrogen atom or the oxygen atom, respectively, being attached to the CO group;
R⁷ is H, C₁-C₆ alkyl, (CₙH₂ₙ)-OH, (CₙH₂ₙ)-PO₃M₂, (CₙH₂ₙ)-OPO₃M₂, (C₆H₄)-PO₃M₂, (C₆H₄)-OPO₃M₂ or (CₙH₂ₙ)-O-(A²O)_{α}-R⁹ with n = 1, 2, 3 or 4
A² is C_{z}H_{2z} with z = 2, 3, 4 or 5 or is CH₂CH(C₆H₅);
α is an integer from 1 to 350; and
R⁹ is H or an unbranched or branched C₁-C₄ alkyl group;
or X is a chemical bond and R² is OM; 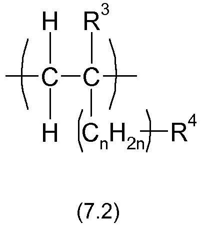
in which
R³ is H or an unbranched or branched C₁-C₄ alkyl group;
n is 0, 1, 2, 3 or 4;
R⁴ is PO₃M₂, or O-PO₃M₂; 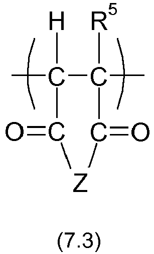
in which
R⁵ is H or an unbranched or branched C₁-C₄ alkyl group;
Z is O or NR⁷; and
R⁷ is H, (CₙH₂ₙ)-OH, (CₙH₂ₙ)-PO₃M₂, (CₙH₂ₙ)-OPO₃M₂, (C₆H₄)-PO₃M₂, or (C₆H₄)-OPO₃M₂, wherein
n is 1, 2, 3 or 4; 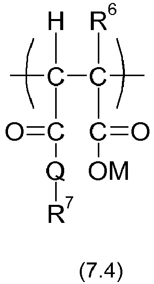
in which
R⁶ is H or an unbranched or branched C₁-C₄ alkyl group;
Q is NR⁷ or O;
R⁷ is H, (CₙH₂ₙ)-OH, (CₙH₂ₙ)-PO₃M₂, (CₙH₂ₙ)-OPO₃M₂, (C₆H₄)-PO₃M₂, (C₆H₄)-OPO₃M₂ or (CₙH₂ₙ)-O-(A²O)_{α}-R⁹,
n is 1, 2, 3 or 4;
A² is C_{z}H_{2z} with z = 2, 3, 4 or 5 or is CH₂CH(C₆H₅);
α is an integer from 1 to 350;
R⁹ is H or an unbranched or branched C₁-C₄ alkyl group;
wherein in formulae (7.1), (7.2), (7.3) and (7.4) each M independently of any other M is H or one cation equivalent
and/or wherein one or more of the side chains comprising a structure unit (ii) - (AO)ₐ-R are selected from general formulae (7.5), (7.6), (7.7) and (7.8): 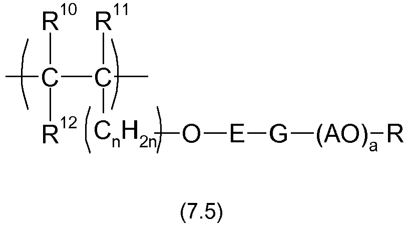 in which
R¹⁰, R¹¹ and R¹² independently of one another are H or an unbranched or branched C₁-C₄ alkyl group;
n is 0, 1, 2, 3, 4 and/or 5;
E is an unbranched or branched C₁-C₆ alkylene group, a cyclohexylene group, CH₂-C₆H₁₀, 1,2-phenylene, 1,3-phenylene or 1,4-phenylene;
G is O, NH or CO-NH; or
E and G together are a chemical bond; 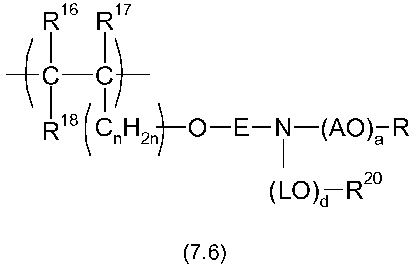
in which
R¹⁶, R¹⁷ and R¹⁸ independently of one another are H or an unbranched or branched C₁-C₄ alkyl group;
n is 0, 1, 2, 3, 4 or 5;
E is an unbranched or branched C₁-C₆ alkylene group, a cyclohexylene group, CH₂-C₆H₁₀, 1,2-phenylene, 1,3-phenylene or 1,4-phenylene or is a chemical bond;
L is C_{z}H_{2z} with z = 2, 3, 4 or 5 or is CH₂-CH(C₆H₅);
d is an integer from 1 to 350;
R²⁰ is H or an unbranched C₁-C₄ alkyl group; 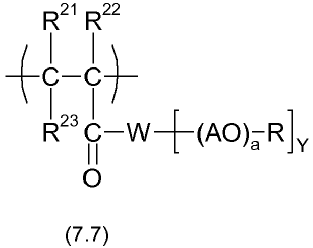
in which
R²¹, R²² and R²³ independently of one another are H or an unbranched or branched C₁-C₄ alkyl group;
W is O, NR²⁵ or N
R²⁵ is H or an unbranched or branched C₁-C₄ alkyl group;
Y is 1, if W = O or NR²⁵, and is 2 if W = N; 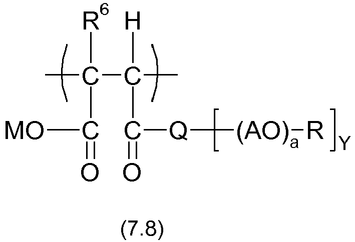
in which
- R⁶: is H or an unbranched or branched C₁-C₄ alkyl group;
- Q: is NR¹⁰, N or O;
- R¹⁰: is H or an unbranched or branched C₁-C₄ alkyl group;
- Y: is 1 if Q = O or NR¹⁰, and is 2 if Q = N.

Particularly preferably the building unit of formula (7.1) is a methacrylic acid or acrylic acid unit, the buidling unit of formula (7.3) is a maleic anhydride unit, and the building unit of formula (7.4) is a maleic acid or maleic monoester unit.

Particularly preferable the building unit of formula (7.5) is an alkoxylated isoprenyl unit, alkoxylated hydroxybutyl vinyl ether unit, alkoxylated (meth)allyl alcohol unit or is a vinylated methylpolyalkylene glycol unit.

In the above-defined comb-polymer, preferably the molar ratio between the total amount of building units of formulae (7.1), (7.2), (7.3) and (7.4) and the total amount of building units of formulae (7.5), (7.6), (7.7) and (7.8) is 1:4 to 15:1, preferably 1:1 to 10:1.

Such comb polymers are obtainable by copolymerization of a monomer selected from the group consisting of acrylic acid; hydroxyalkyl acrylates; methacrylic acid; hydroxyalkyl methacrylates, maleic acid, itaconic acid, 2-Acrylamido-2-methylpropane sulfonic acid (AMPS); acrylamide and
phosphoric acid hydroxalkylmethacrylate 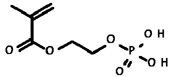 with one or more macromers selected from the group consisting of alkoylated vinyl ethers (e.g. ethoxylated hydroxybutyl vinyl ester), alkoxylated allyl ethers, alkoxylated methallyl ethers, alkoxylated Isoprenyl ethers, methacrylic acid esters of polyalkyleneoxide monoalkylethers, acrylic acid esters of polyalkyleneoxide monoalkylethers, maleic acid esters of polyalkyleneoxide monoalkyl ethers. Said alkoxylated macromers each comprise a structure unit -(AO)ₐ-R whrein A is CₓH₂ₓ wherein for each A in said structure units -(AO)ₐ-R, x is (independently from each other x) selected from the range of integers from 2 to 4, wherein x is preferably 2 or 3, further preferably x =2.

Preferably, electron-rich macromers are reacted with electron-deficient monomers, i.e. vinyl ether monomers with acrylic or maleic monomers.

Suitable ways for obtaining the above-defined comb polymer are disclosed in the European patent application having the application number 13156752.1.

A preferred comb polymer of this type is available under the trade name MelPers 0045 from BASF SE. In said comb polymer, the back bone is formed of acrylic and maleic acid monomers, the structure units -(AO)ₐ-R each have a molar mass of 5800 g/mol, A is -CH₂-CH₂-, R is H and the sum of the molar masses of all said structure units -(AO)ₐ-R is 94 % of the molar mass of said comb polymer.

A further kind of polymer (B) suitable for the present invention is a comb polymer obtainable by copolymerisation of the monomers
(8.1) acrylic acid and
(8.2) one or more macromers each comprising a polymerizable double bond, preferably a double bond of a vinyl group, an allyl group, an isoprenyl group, an acrylate group, a methacrylate group or a maleic ester group,
   A is CₓH₂ₓ wherein for each A in said structure units -(AO)ₐ-R, x is (independently from each other x) selected from the range of integers from 2 to 4, wherein x is preferably 2 or 3, further preferably x =2
   wherein within each structure unit -(AO)ₐ-R the groups A are the same or different a is an integer selected from the range of from 5 to 200, preferably 8 to 150, most preferably 20 to 135
   R is hydrogen or a branched or linear alkyl group having 1 to 4 carbon atoms,
wherein the amounts of the monomers (8.1) and (8.2) are selected so that a comb polymer is obtained wherein in said comb polymer the sum of the molar masses of all said structure units (ii) -(AO)ₐ-R is at least 70 % of the molar mass of said comb polymer.

In a preferred comb polymer of this type, the backbone is formed of polyacrylic acid, the structure units -(AO)ₐ-R each have a molar mass of 1100 g/mol, A is -CH₂-CH₂-, R is H and the sum of the molar masses of all said structure units -(AO)ₐ-R is 75 % of the molar mass of said comb polymer.

A further kind of polymer (B) suitable for the present invention is a comb polymer which is a polycondensate containing
(9.1) at least one building unit comprising an aromatic or heteroaromatic system Ar¹ and a side chain comprising or consisting of a structure unit (ii) -(AO)ₐ-R
   wherein in each building unit (9.1) independently from each other building unit (9.1) A is CₓH₂ₓ wherein for each A in said structure units -(AO)ₐ-R, x is (independently from each other x) selected from the range of integers from 2 to 4, wherein x is preferably 2 or 3, further preferably x =2
   wherein within each structure unit -(AO)ₐ-R the groups A are the same or different a is an integer selected from the range of from 5 to 200, preferably 8 to 150, most preferably 20 to 135
   R is hydrogen or a branched or linear alkyl group having 1 to 4 carbon atoms,
   wherein preferably the building units (9.1) are represented by general formula (9.1) 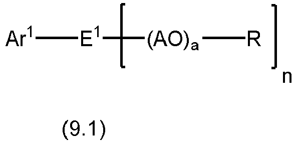 wherein for each building unit of formula (9.1) independently from each other building unit of formula (9.1)
   Ar¹ is selected from the group consisting of unsubstituted aromatic or heteroaromatic systems having 5 to 10 carbon atoms in each case
   E¹ is selected from the group consisting of N, NH and O, preferably O
   n = 2 if E¹ = N and n = 1 if E¹ = NH or O
   A, a and R are as defined above
(9.2) at least one building unit comprising an aromatic or heteroaromatic system Ar¹ and a phosphoric group
   wherein preferably one or more of the building units (9.2) are represented by general formula (9.2) 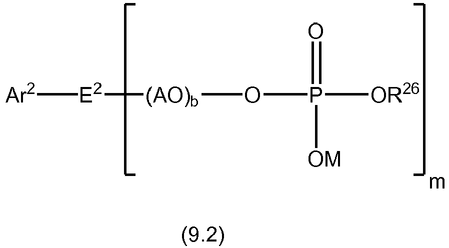 wherein for each building unit of formula (9.2) independently from each other building unit of formula (9.2)
   Ar² is selected from the group consisting of unsubstituted aromatic or heteroaromatic system having 5 to 10 carbon atoms in each case
   E² is selected from the group consisting of N, NH and O, preferably O
   m = 2 if E² = N and m = 1 if E² = NH or O
   A is as defined above for building unit (9.1)
   b is an integer selected from the range of from 0 to 300, preferably 1 to 5
   M independently of any other M is H or one cation equivalent,
   R²⁶ is M or Ar¹-O-(AO)ₐ-
(9.3) at least one building unit comprising an aromatic or heteroaromatic system Ar², wherein building unit (9.3) differs from building unit (9.2) exclusively in that the phosphonic group of the building unit (9.2) is replaced by H in building unit (9.3), and building unit (9.3) is not the same as building unit (9.1)
   wherein preferably the building unit (9.3) is represented by general formula (9.3) 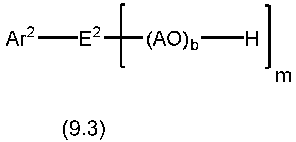 wherein for each building unit of formula (9.3) independently from each other building unit of formula (9.3) Ar², E², m, A and b are as defined for building unit (9.2)

In the building units (9.1), (9.2) and (9.3) of said polycondensates the aromatic or heteroaromatic systems Ar¹ and Ar², resp., are preferably represented by or derived from phenyl, 2-hydroxyphenyl, 3-hydroxyphenyl, 4-hydroxyphenyl, 2-methoxyphenyl, 3-methoxyphenyl, 4-methoxyphenyl, naphthyl, 2-hydroxynaphthyl, 4-hydroxynaphthyl, 2-methoxynaphthyl, 4-methoxynaphthyl. Preferably, the aromatic or heteroaromatic systems Ar¹ and Ar², are phenyl.

The above-defined polycondensate preferably contains a further building unit (9.4) which is represented by the following formula 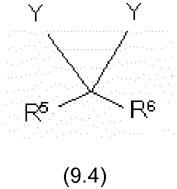 where
Y, independently of one another, are identical or different and are building units (9.1), (9.2), (9.3) or further constituents of the polycondensate
   where
R⁵ are identical or different and are represented by H, CH₃, COOH or a substituted or unsubstituted aromatic or heteroaromatic system having 5 to 10 C atoms
   where
R⁶ are identical or different and are represented by H, CH₃, COOH or a substituted or unsubstituted aromatic or heteroaromatic system having 5 to 10 carbon atoms. Preferably R⁵ and R⁶ in building unit (9.4) independently of one another, are identical or different and are represented by H, COOH and/or methyl.

In said polycondensate, preferably
the molar ratio of the building units [(9.1) + (9.2) + (9.3)]:(9.4) is in the range of from 1:0.8 to 3, preferably 1:0.9 to 2 and particularly preferably 1:0.95 to 1.2.
and/or
the molar ratio of the building units (9.1):[(9.2) + (9.3)] is in the range of from 1:10 to 10:1, preferably 1:7 to 5:1 and particularly preferably 1:5 to 3:1.
and/or
the molar ratio of the building units (9.2):(9.3) is in the range of from 1 :0.005 to 1:10, preferably 1:0.01 to 1:1, in particular 1:0.01 to 1:0.2 and particularly preferably 1:0.01 to 1:0.1.

In the process for the preparation of said polycondensate, polycondensation and the introduction of the phosphoric group (phosphatizing) are preferably carried out in a reaction mixture. Preferably, the reaction mixture used in this process contains at least
(9.1a) a monomer having aromatic or heteroaromatic system Ar¹ and a side chain comprising or consisting of a structure unit (ii) -(AO)ₐ-R
(9.3a) a monomer having an aromatic or heteroaromatic system, said monomer (9.3a) being partially phosphatized during the reaction and thus forming a monomer (9.2a) and/or, in the polycondensate, the building unit (9.2),
(9.4a) a monomer having an aldehyde group, e.g. fomaldehyde, and a phosphatizing agent, e.g. polyphosphoric acid and/or phosphorous pentoxide.

Suitable ways for obtaining the above-defined polycondensates are disclosed in WO2010/040612.

A preferred comb polymer of this type is available under the trade name EPPR 312 from BASF SE. In said comb polymer, the structure units -(AO)ₐ-R each have a molar mass of 5000 g/mol, A is -CH₂-CH₂-, R is H and the sum of the molar masses of all said structure units (ii) -(AO)ₐ-R is 83 % of the molar mass of said comb polymer, and the molar ratio of the building units (9.1):[(9.2) + (9.3)] is 1:4.

A further kind of polymer (B) suitable for the present invention is disclosed in US 5,879,445 and has a structure of the formula (10) 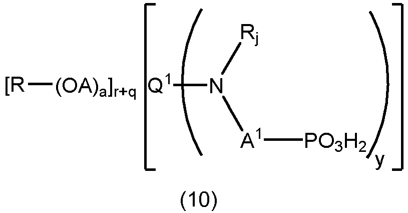 wherein
- A is CₓH₂ₓ wherein for each A in said structure units -(AO)ₐ-R, x is (independently from each other x) selected from the range of integers from 2 to 4, wherein x is preferably 2 or 3, further preferably x =2, wherein within each structure unit -(AO)ₐ-R the groups A are the same or different
- a is an integer selected from the range of from 5 to 200, preferably 8 to 150, most preferably 20 to 135
- R is hydrogen or a branched or linear alkyl group having 1 to 4 carbon atoms, wherein R is preferably selected from the group consisting of hydrogen and methyl,
- Q¹ is a hydrocarbon group comprising 2 to 18 carbon atoms and possibly one or more heteroatoms,
- A¹ is an alkylene group comprising 1 to 5 carbon atoms,
- the Rⱼ groups are independently from each other selected from the group consisting of:
   - the A¹-PO₃H₂ group, wherein A¹ has the above-defined meaning,
   - the alkyl group comprising 1 to 18 carbon atoms and able to carry -(AO)ₐ-R groups
      and
   - the group 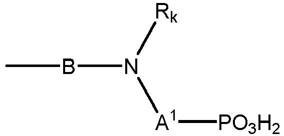 wherein B designates an alkylene group having 2 to 18 carbon atoms,
- r is the number of structure units -(AO)ₐ-R carried by all the Rⱼ groups,
- q is the number of structure units -(AO)ₐ-R carried by Q,
- the sum "r+q" is selected so that in said polymer (B) the sum of the molar masses of all said structure units -(AO)ₐ-R is at least 50 % of molar mass of said polymer (B) preferably 90 % or more, based on the molar mass of said polymer
- y is an integer in the range of from 1 to 3, wherein when y > 1, the groups 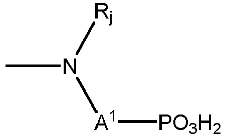 are the same or different
- Q¹, N, and the Rⱼ groups can form together one or more rings, this ring or these rings moreover able to contain one or more other heteroatoms.

Suitable ways for obtaining polymers (B) of formula (10) are disclosed in US 5,879,445.

The group Q¹ preferably has 2 to 12 carbon atoms (inclusive), and more preferably, it has 2 to 6 carbon atoms (inclusive). Advantageously, Q¹ is chosen from among ethylene, cyclohexene or n-hexene.

The alkylene group A¹ which is the carrier of one divalent carbon atom has preferably 1 to 3 carbon atoms (inclusive). It is particularly advantageous that A¹ is the methylene group.

The Rⱼ group, which is possibly combined in salt form, is chosen preferably from among the -CH₂-PO₃H₂, methyl, and -C₂H₄N(CH₂-PO₃H₂)₂ groups. More preferably still, Rⱼ represents the -CH₂-PO₃H₂ group.

The sum "r+q" corresponds to the total number of polyoxyalkylated chains. Preferably, this sum is less than 3. More preferably, it is equal to 1.

"y" is a number comprised between 1 and 3 inclusive. It is preferably equal to 1.

R is preferably H, A is preferably -CH₂-CH₂- and a is preferably 50.

According to US 5,879,445, preferred compounds of formula (10) as defined above are 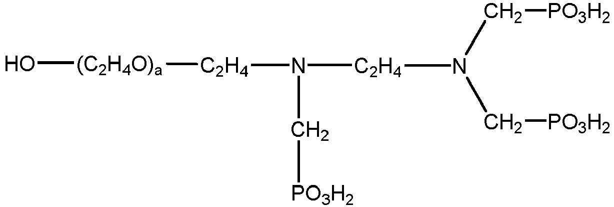 and 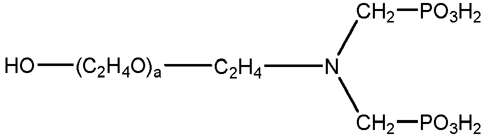 wherein a is preferably 50.

A preferred polymer (B) of this type is hereinbelow referred to as Stab 100. In said polymer Stab 100 the structure units -(AO)ₐ-R each have a molar mass of 3000 g/mol, A is -CH₂-CH₂-, R is H and the sum of the molar masses of all said structure units -(AO)ₐ-R is 92 % of the molar mass of said polymer.

Without wishing to be bound to any specific theory, it is presently assumed that the structure units (ii) -(AO)ₐ-R (wherein A, a and R are as defined above) present in the polymers (B) stabilize the ceria-containing abrasive particles (A) in a non-ionic steric manner while the negatively charged anionic functional groups anchor the polymers (B) to the positively charged ceria-containing abrasive particles (A). The steric stabilization is assumed to be due to a screening (shielding) effect of the structure units -(AO)ₐ-R present on the surface of the ceria-containing abrasive particles (A). Accordingly, it is important that in the polymers (B) to be used according to the present invention a significant part of each macromolecule is formed of screening structure units -(AO)ₐ-R. This steric stabilization effect could not be achieved with polymers having no or not a sufficient fraction of screening structure units, e.g. polymers wherein the fraction of anionic groups in the macromolecules is significantly larger than in the above-defined polymers to be used according to the invention (e.g. carboxylic acid homopolymers like polyacrylic acid and polyaspartic acid, which form polyanions with a large amount of negative charge). At least for this reason it is important that in said polymer (B) the sum of the molar masses of the structure units -(AO)ₐ-R which provide for the screening effect is at least 50 % of the molar mass of said polymer (B). On the other hand, the presence of anionic groups (i) is necessary in order to enable anchoring of the polymer (B) to the positively charged surface of the abrasive particles (A) containing ceria. Furthermore, in order to provide for reliable and efficient anchoring by the anionic functional groups (i) and screening by the structure units (ii) -(AO)ₐ-R, it is important that there is no random distribution of anionic functional groups (i) and structure units (ii) -(AO)ₐ-R within the polymer.

In this way, the charge of the ceria-containing abrasive particles (A) is minimized and at the same time agglomeration (flocculation) of the abrasive particles is suppressed, even at a pH in the range of 6 to 10, preferably up to 10.8 or at least in a significant subrange of this pH range.

Abrasive particles carrying a low charge are especially preferably for polishing surfaces of dielectric materials like silicon dioxide and silicon nitride, because when the charge of the abrasive particles is low, electrostatic interaction between the abrasive particles and the charged surface of the to-be-polished dielectric which is detrimental to the CMP process (see above) is reduced.

Especially for chemical-mechanical polishing of silicon dioxide, a CMP composition having a pH of more than 6 is desirable because it allows for alkaline chemical hydrolysis of silicon dioxide which supports the removal mechanism and helps in preventing scratches which are visible after the chemical mechanical polishing process.

Accordingly, it is preferred that in a chemical-mechanical polishing (CMP) composition according to the present invention the concentration of said one or more polymers (B) as defined hereinabove is selected so that
- no flocculation of ceria containing particles (A) occurs in the pH range of from 6 to 10, preferably up to 10.8
   and/or
- at a pH in the range of from 6 to 10 the zeta potential of the particles containing ceria is in the range between +30 mV and - 30 mV, preferably between + 20 mV and - 20 mV.

In the chemical-mechanical polishing (CMP) composition according to the present invention, the total amount of polymers (B) as defined hereinabove is in a range of from 0.0002 to 1.0 wt.-%, preferably 0.001 wt.-% to 0.1 wt.-%, more preferably 0.005 wt.-% to 0.025 wt.-%, further preferably 0.0075 wt.-% to 0.01 wt.-%, in each case based on the total weight of the respective CMP composition.

In this regard, further aspects related to the present invention are directed to
- the use of a polymer (B) as defined hereinabove for suppressing the agglomeration of ceria containing particles dispersed in aqueous medium and/or for adjusting the zeta potential of ceria containing particles
   and
- a process for suppressing the agglomeration and/or adjusting the zeta potential of ceria containing particles dispersed in aqueous medium, said process comprising the step of adding an effective amount of one or more polymers (B) as defined hereinabove to said aqueous medium wherein the containing ceria particles are dispersed.

### (C) Polyhydroxy compounds

For certain applications, a chemical mechanical polishing (CMP) composition according to the present invention preferably further comprises
(C) one or more polyhydroxy compounds.
Including one or more polyhydroxy compounds (C) in the CMP composition of the present invention in preferred cases is helpful in improving the polishing performance, particularly the combination of high material removal rate of silicon dioxide and low material removal rate of silicon nitride and/or polycrystalline silicon.

Polyhydroxy compounds (also referred to as polyols) are organic compounds comprising two or more alcoholic hydroxy groups per molecule. Typical representatives of polyhydroxy compounds are diols (e.g. glycols, including polyalkylene glycols), glycerol, carbohydrates and sugar alcohols.

Preferred polyhydroxy compounds (C) are selected from the group consisting of mannitol, sorbitol, xylitol, mannose, sorbose, dextrin, glucose, gelatin, taragum, cationic guar gum, collagen, dextrin, tragacanth, propylene glycol alginate, cyclodextrin, chitin, hyaluronic acid, carmelose, starch, cyprogum, bee gum, pullulan, laponite, pectin, trehalose, casein, saccharose, maltose, fructose, mannose, glucuronic acid, glucosamine, glucosan, cationic cellulose, glucosidase, glucose phenylosazone, hydroxyethylcellulose, chitosan, starch phosphate, soybean lecithin, xanthan gum, tamalind gum, locust bean gum, tamalindsy gum, arabic gum, cyliumseed gum, caragynan, gelan gum, guar gum polyglycerol fatty acid ester, polysaccharides, such as starch, chitosan, algenic acid, carboxy methyl cellulose, methyl cellulose, curdlan and derivatives thereof, Xanthan Gum, Guaiac gum, Mastic Gum and Rosin Gumgluconic acid, glucono (acid) delta lacton, and glycosides, especially alkyl poly glycosides.

In preferred cases the polyhydroxy compound (C) or one of the polyhydroxy compounds (C) is a glycoside of the formulae 1 to 6 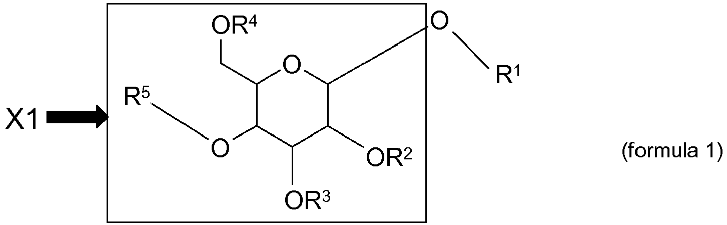 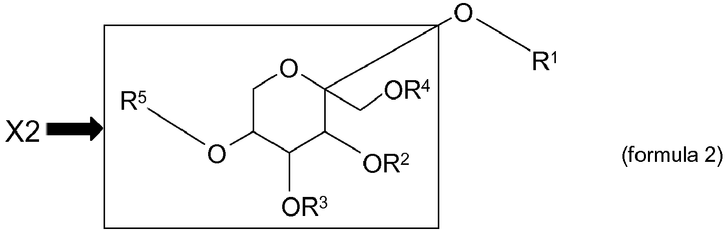 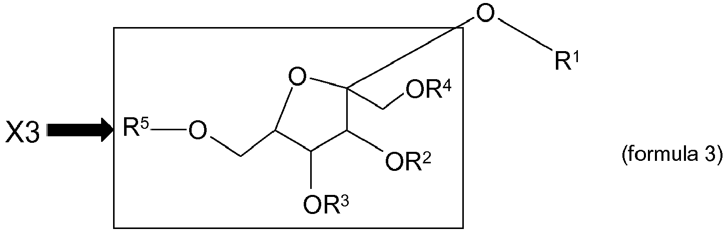 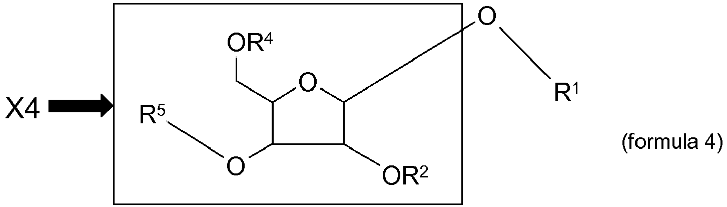 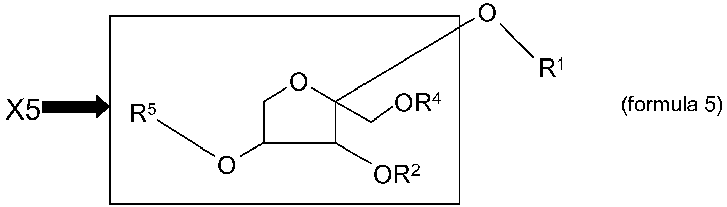 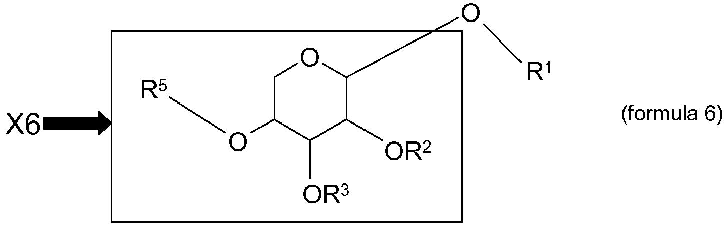 wherein
R¹ is alkyl, aryl, or alkylaryl,
R² is H, X1, X2, X3, X4, X5, X6, alkyl, aryl, or alkylaryl,
R³ is H, X1, X2, X3, X4, X5, X6, alkyl, aryl, or alkylaryl,
R⁴ is H, X1, X2, X3, X4, X5, X6, alkyl, aryl, or alkylaryl,
R⁵ is H, X1, X2, X3, X4, X5, X6, alkyl, aryl, or alkylaryl,
the total number of monosaccharide units (X1, X2, X3, X4, X5, or X6) in the glycoside is in the range of from 1 to 20,
and X1 to X6 are the structural units as indicated in the rectangles in the corresponding formulae 1 to 6.

In the glycosides of formulae 1 to 6, the total number of monosaccharide units (X1, X2, X3, X4, X5, or X6) is preferably in the range of from 1 to 5.

Further preferably, the glycoside is a glycoside of formula 1 and wherein R¹ is alkyl, aryl, or alkylaryl, R² is H or X1, R³ is H or X1, R⁴ is H or X1, R⁵ is H or X1.

Particularly preferably, the glycoside is a glycoside of formula 1a 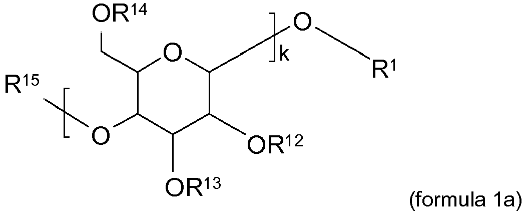 wherein
R¹ is alkyl, aryl or alkylaryl,
R¹² is H, alkyl, aryl or alkylaryl, preferably H,
R¹³ is H, alkyl, aryl or alkylaryl, preferably H,
R¹⁴ is H, alkyl, aryl or alkylaryl, preferably H,
R¹⁵ is H, alkyl, aryl or alkylaryl, preferably H,
and k is an integer from 1 to 20, preferably from 1 to 5.

Preferably, in formula (1a), R¹², R¹³, R¹⁴ and R¹⁵ are H.

Preferably, in formula (1a),
R¹ is 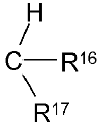 wherein R¹⁶ is H, alkyl, aryl or alkylaryl, and R¹⁷ is H, alkyl, aryl or alkylaryl, or
R¹ is CH₂R¹⁸, and R¹⁸ is H, alkyl, aryl or alkylaryl.

Particularly preferred is a chemical-mechanical polishing (CMP) composition according to the present invention, wherein the total amount of polyhydroxy compounds (C) as defined hereinabove is in a range of from 0.001 wt.-% to 2 wt.-%, preferably 0.01 wt.-% to 1 wt.-%, for example 0,02 wt.-% to 0.05 wt.-%% in each case based on the total weight of the respective CMP composition.

### (D) pH adjustors

Further preferably, a chemical-mechanical polishing (CMP) composition according to the present invention further comprising
(D) one or more pH adjustors.

Suitable pH adjustors are selected from the group consisting of ammonia, KOH, NaOH; M₂CO₃, M(HCO₃)₂, where in each case M is selected from the group consisting of K, Na, NH₄ and tetra-alkyl-ammonium, tetraakylammonium hydroxides like etramethylammonium hydroxide (TMAH) and tetraethylammonium hydroxide (TEMH), alkyl substitued amines like tri-methyhl-amine, tri-ethyl-amine, di-methyl-amine, di-ethyl-amine, methyl-amine; ethyl-aminpolyamines like diethylen-tri-amine, hexamethylene-tri-amine or urotropin, polymeric imines like polyethylenimine, nitric acid, phosphoric acid, sulfuric acid, hydrochloric acid, formic acid, phosphonic acids, sulfonic acids, wherein ammonia, KOH, TMAH, TEAH; nitric acid, formic acid are poreferred.

The pH value of the CMP composition according to the present invention is in the range of from 6 to 10, more preferably from 6.5 to 9.5, further preferably from 7 to 9, still further preferably from 7.5 to 8.5, for example 8.

Particularly preferred is a chemical-mechanical polishing (CMP) composition according to the present invention, wherein
(A) the total amount of abrasive particles containing ceria is in a range of from 0.01 wt.-% to 5 wt.-%, preferably 0.1 wt.-% to 1.0 wt.-%, for example 0.5 wt.-%, in each case based on the total weight of the respective CMP composition,
   and
(B) the total amount of polymers (B) as defined hereinabove is in a range of from 0.0002 wt.-% to 1 wt.-%, preferably 0.001 wt.-% to 0.1 wt.-%, more preferably 0.005 wt.-% to 0.025 wt.-%, further preferably 0.0075 wt.-% to 0.01 wt.-%, in each case based on the total weight of the respective CMP composition.
   and
(C) the total amount of polyhydroxy compounds is in a range of from 0.001 wt.-% to 2 wt.-%, preferably 0.01 wt.-% to 1 wt.-% in each case based on the total weight of the respective CMP composition.

### Further components of the CMP composition

The CMP compositions according to the invention may further contain, if necessary, various other coomponents, including but not limited to biocides. The biocide is different from the components (A), (B), (C) and (D) as defined hereinabove. In general, the biocide is a compound which deters, renders harmless, or exerts a controlling effect on any harmful organism by chemical or biological means. Preferably, the biocide is a quaternary ammonium compound, an isothiazolinone-based compound, an *N*-substituted diazenium dioxide, or an *N'*-hydroxy-diazenium oxide salt. More preferably, the biozide is an N-substituted diazenium dioxide, or an *N'*-hydroxy-diazenium oxide salt.

### Preparation of a CMP composition according to the present invention

In a further aspect, the present invention relates to a process for preparing a CMP composition according to the present invention (as defined hereinabove). The process comprises the step of combining
(A) abrasive particles containing ceria
(B) one or more polymers as defined hereinabove
in an aqueous medium.

Processes for preparing CMP compositions are generally known. These processes may be applied to the preparation of the CMP composition used according to the present invention. This can be carried out by dispersing the above-described component (A) and dissolving the above-described component (B), and if appropriate the above-described optional further component (C) in water, and optionally by adjusting the pH value through adding a pH adjustor (D) as defined hereinabove or hereinbelow. For this purpose the customary and standard mixing processes and mixing apparatuses such as agitated vessels, high shear impellers, ultrasonic mixers, homogenizer nozzles or counterflow mixers, can be used. The pH value of the CMP composition according to the present invention is adjusted in the range of from 6 to 10, more preferably from 6.5 to 9.5, further preferably from 7 to 9, still further preferably from 7.5 to 8.5, for example 8.

Preferably, a process for preparing a CMP composition according to the present invention (as defined hereinabove) comprises the step of adding one or more polymers (B) as defined hereinabove to an aqueous suspension comprising abrasive particles containing ceria (A).

### Chemical mechanical polishing using the CMP composition of the present invention

In a further aspect the present invention relates to a process for the manufacture of a semiconductor device comprising the step of chemical mechanical polishing of a substrate in the presence of a chemical mechanical polishing (CMP) composition according to the present invention as defined hereinabove. In the step of chemical mechanical polishing, the pH value of the CMP composition is in the range of from 6 to 10, more preferably from 6.5 to 9.5, further preferably from 7 to 9, still further preferably from 7.5 to 8.5, for example 8.

The chemical-mechanical polishing step is generally known and can be carried out with the processes and the equipment under the conditions customarily used for the CMP in the fabrication of wafers with integrated circuits.

In a preferred process according to the present invention, the substrate comprises
- a surface region or a layer consisting of silicon dioxide
   and
- a surface region or a layer consisting of silicon nitride or polycrystalline silicon.

In preferred cases, the silicon dioxide layer to be polished by the CMP composition according to the present invention is a silicon dioxide layer of a substrate which is a shallow trench isolation (STI) device or a part thereof.

### Examples

The invention is hereinafter further illustrated by means of examples and comparison examples.

### Preparation of the CMP compositions:

The polymer (B) as defined hereinbelow and optionally a polyhydroxy compound (C) as defined hereinbelow are added to a commercially available solution of colloidal ceria.

The following polymers (B) are used

| polymer (B) | supplier | Anionic group (i) | molar mass of structure unit (ii) | Percentage of molar mass of all structure units (ii) based on the molar mass of polymer (B) |
|---|---|---|---|---|
| EPPR 312 | BASF SE | phosphoric group | 5000 | 83 |
| Melpers 0045 | BASF SE | carboxylic group | 5800 | 94 |
| Stab 0557 (comb polymer having a backbone formed of polyacrylic acid) | | carboxylic group | 1100 | 75 % |
| Stab100 | | phosphonic group | 3000 | 92 % |

For comparison, CMP compositions not containing any polymer (B) are also tested.

The pH of each composition is adjusted by adding of aqueous ammonia solution (0.1%) or HNO₃ (0.1 %). The pH is measured with a pH combination electrode (Schott, blue line 22 pH).

The concentration of ceria (either wet-precipitated, tradename HC 60 from Rhodia, or fumed, tradename NanoArc 6440 from NanoPhase) is in each case 0.5 wt.-%, based on the weight of the respective CMP composition.

Wet-precipitated ceria particles (for example Rhodia HC60) as obtained from supplier have a mean primary particle size of 60 nm (as determined using BET surface area measurements) and a mean secondary particle size (d50 value) of 99 nm (as determined using dynamic light scattering techniques via a Horiba instrument).

Fumed ceria particles (for example NanoArc 6440) as obtained from supplier have a mean primary particle size of 30 nm (as determined using BET surface area measurements) and a mean secondary particle size (d50 value) of 130 nm (as determined using dynamic light scattering techniques via a Horiba instrument).

If not indicated otherwise, wet-precipitated ceria is used. For further information about the components of the CMP compositions, see the tables in the section "results" hereinbelow.

### CMP experiments

Several comparative CMP compositions (see the tables in the result section) were used for chemical mechanical polishing 200 mm diameter wafers coated with either silicon dioxide, silicon nitride and polycrystalline silicon.

The polishing parameters are as follows:

| | |
|---|---|
| CMP device: | Strasbaugh nSpire (Model 6EC) with ViPRR floating retaining ring Carrier; |
| down pressure: | 2.0 psi (140 mbar); |
| back side pressure: | 0.5 psi (34.5 mbar); |
| retaining ring pressure: | 2.5 psi (172 mbar); |
| polishing table / carrier speed: | 95 / 85 rpm; |
| slurry flow rate: | 200 ml / min; |
| polishing time: | 60 s; |
| pad conditioning: | in situ (4 lbs, 17,8 N); |
| polishing pad: | IC1000 A2 stacked pad, x,y k or k grooved (R&H); |
| backing film: | Strasbaugh, DF200 (136 holes); |
| conditioning disk: | 3M S60; |

For studying the material removal of silicon dioxide (SiO₂), substrates coated with a silicon dioxide layer obtained by plasma-enhanced chemical vapor deposition using tetra ethyl ortho silicate (TEOS) as the precursor were used.

For studying the material removal of silicon nitride (Si₃N₄), substrates coated with a silicon nitride layer obtained by plasma-enhanced chemical vapor deposition were used.

For studying the material removal of polycrystalline silicon (poly-Si), substrates coated with a polycrystalline silicon layer obtained from chemical vapor deposition were used.

For silicon dioxide, the material removal is determined based on the difference of weight before and after the chemical mechanical polishing, based on a density of SiO₂ of 1.9 kg/l. The weight is measured by means of a Sartorius LA310 S scale. For silicon nitride and polycrystalline silicon, the material removal is determined based on the difference of the film thickness of the substrates before and after the chemical mechanical polishing. The film thickness (average thickness of diameter scan) is measured by means of a Filmmetrics F50 reflectometer. For calculating the material removal rate (MRR) the total material removal as determined above is divided by the time of the main polishing step.

The selectivity for removing silicon dioxide vs. silicon nitride (SiO₂/Si₃N₄) is the ratio between the material removal rates of silicon dioxide and silicon nitride. The selectivity for removing silicon dioxide vs. polycrystalline silicon (SiO₂/poly-Si) is the ratio between the material removal rates of silicon dioxide and polycrystalline silicon.

### Results of the CMP experiments

The results of the CMP experiments are given in tables 1-8 hereinbelow.

**Table 1 CMP compositions comprising EPPR 312 as polymer (B) : the compositions having a pH outside the range 6.0-10.0 are control compositions.**

| Concentration of EPPR 312 [wt.-%] | pH | MRR SiO₂ [A/min] | Selectivity SiO₂/Si₃N₄ | Selectivity SiO₂/poly-Si |
|---|---|---|---|---|
| 0 | 5.5 | 3293 | 7 | 11 |
| 0.01 | 4 | 1280 | 5 | 11 |
| 0.01 | 5 | 2432 | 23 | 22 |
| 0.01 | 6 | 2768 | 24 | 15 |
| 0.005 | 6 | 1280 | 5 | 11 |
| 0.005 | 8 | 2432 | 23 | 22 |

CMP compositions comprising EPPR312 as polymer (B) in the above-indicated amounts are stable at the pH values given in table 1. In some cases the selectivities SiO₂/Si₃N₄ and/or SiO₂/poly-Si are improved in the presence of EPPR312.

**Table 2 CMP compositions comprising EPPR 312 as polymer (B) ans a polyhydroxy compound (C) : the compositions having a pH outside the range 6.0-10.0 are control compositions.**

| concentration of EPPR 312 [wt.-%] | pH | polyhydroxy compound (C) | concentration of (C) [wt.-%] | MRR SiO₂ [A/min] | Selectivity SiO₂/Si₃N₄ | Selectivity SiO₂/poly-Si |
|---|---|---|---|---|---|---|
| 0.01 | 6 | alkylpoly-glycoside (Glucopon 225 DK) | 0.01 | 2262 | 103 | 84 |
| 0.0075 | 5.5 | | 0.075 | 2221 | 53 | 26 |
| 0.005 | 5 | | 0.05 | 1991 | 50 | 39 |
| 0.01 | 6 | galactose | 0.5 | 1852 | 154 | 36 |
| 0.005 | 6 | | 0.5 | 2967 | 106 | 11 |
| 0.01 | 6 | innositol | 0.5 | 1551 | 67 | 39 |

Combination of EPPR312 as polymer (B) with polyhydroxy compounds (C) at the pH values as listed in table 2 results in a significant improvements of the selectivities SiO₂/Si₃N₄ and SiO₂/poly-Si, compared to CMP compositions comprising either no polymer (B) or EPPR312 as polymer (B) but no polyhydroxy compound (C).

**Table 3: CMP compositions comprising Melpers 0045 as polymer (B) : the compositions having a pH outside the range 6.0-10.0 are control compositions.**

| Concentration of MelPers 0045 [wt.-%] | pH | MRR SiO₂ [A/min] | Selectivity SiO₂/Si₃N₄ | Selectivity SiO₂/poly-Si |
|---|---|---|---|---|
| 0 | 5.5 | 3293 | 7 | 11 |
| 0.05 | 9 | 1725 | 72 | 173 |
| 0.025 | 7 | 2044 | 21 | 76 |
| 0.025 | 9 | 2478 | 38 | 165 |

CMP compositions comprising Melpers 0045 as polymer (B) in the above-indicated amounts are stable at the pH values given in table 3. The selectivities SiO₂/Si₃N₄ and/or SiO₂/poly-Si are remarkably improved in the presence of Melpers 0045, especially at pH = 9.

**Table 4: CMP compositions comprising Melpers 0045 as polymer (B) and polyhydroxy compounds (C) : the compositions having a pH outside the range 6.0-10.0 are control compositions.**

| concentration of Melpers 0045 [wt.-%] | pH | conc.of PEG [wt.-%] | further polyhydroxy compound (C) | conc. of (C) [wt.-%] | MRR SiO₂ [A/min] | Selectivity SiO₂/Si₃N₄ | Selectivity SiO₂/poly-Si |
|---|---|---|---|---|---|---|---|
| 0 | 5.5 | 0 | - | 0 | 3293 | 7 | 11 |
| 0 | 5 | 0.4 | - | 0 | 2804 | 7 | 47 |
| 0.025 | 7 | 0.2 | - | 0 | 1791 | 24 | 128 |
| 0.025 | 9 | 0.2 | - | 0 | 1872 | 33 | 69 |
| 0.025 | 9 | 0.2 | sucralose | 0.1 | 1938 | 55 | 323 |
| 0.025 | 5 | 0 | alkylpoly-glycoside (Glucopon 225 DK) | 0.05 | 1902 | 59 | Not meas- |
| 0.025 | 7 | 0 | | 0 | 2220 | 10 | 62 |
| 0.025 | 7 | 0 | | 0.05 | 2922 | 66 | 97 |

The PEG is a polyethylene glycol having a molar mass of 10000 g/mol, available from Aldrich. In the last two CMP compositions of table 4, the abrasive particles (A) are fumed ceria.

Combination of Melpers 0045 as polymer (B) with polyhydroxy compounds (C) as listed above at the pH values given in table 4 results in suitable selectivities SiO₂/Si₃N₄ and SiO₂/poly-Si, compared to CMP compositions comprising no polymer (B).

**Table 5: CMP compositions comprising Stab 100 as polymer (B)**

| Concentration of Stab 100 [wt.-%] | pH | MRR SiO₂ [A/min] | Selectivity SiO₂/Si₃N₄ | Selectivity SiO₂/poly-Si |
|---|---|---|---|---|
| 0 | 5.5 | 3293 | 7 | 11 |
| 0.01 | 8 | 2565 | 6 | 13 |

CMP compositions comprising Stab 100 as polymer (B) in the above-indicated amount are stable at pH = 8, see table 5. The selectivities SiO₂/Si₃N₄ and SiO₂/poly-Si are not significantly changed in the presence of Stab 100.

**Table 6: CMP compositions comprising Stab 100 as polymer (B) and polyhydroxy compounds (C)**

| concentration of Stab 100 [wt.-%] | pH | polyhydroxy compound (C) | concentration of (C) [wt.-%] | MRR SiO₂ [A/min] | Selectivity SiO₂/Si₃N₄ | Selectivity SiO₂/poly-Si |
|---|---|---|---|---|---|---|
| 0.01 | 8 | galactose | 0.25 | 2338 | 37 | 21 |
| 0.01 | 8 | Alkylpoly-glycoside (Glucopon 225 DK) | 0.1 | 2660 | 106 | 121 |

Combination of Stab 100 as polymer (B) with a polyhydroxy compound (C) as listed in table 6 at pH =8 results in improved selectivities SiO₂/Si₃N₄ and SiO₂/poly-Si, compared to CMP compositions comprising no polymer (B) or Stab 100 as polymer (B) but no polyhydroxy compound (C).

**Table 7: CMP compositions comprising Stab0557 as polymer (B)**

| Concentration of Stab0557 [wt.-%] | pH | MRR SiO₂ [A/min] | Selectivity SiO₂/Si₃N₄ | Selectivity SiO₂/poly-Si |
|---|---|---|---|---|
| 0 | 5.5 | 3293 | 7 | 11 |
| 0.01 | 8 | 1763 | 35 | 80 |

CMP compositions comprising Stab 100 as polymer (B) in the above-indicated amount are stable at pH = 8, see table 7. The selectivities SiO₂/Si₃N₄ and SiO₂/poly-Si are significantly increased in the presence of Stab 100.

**Table 8: CMP compositions comprising Stab0557 as polymer (B) and a polyhydroxy compound (C)**

| concentration of Stab0557 [wt.-%] | pH | polyhydroxy compound (C) | concentration of (C) [wt.-%] | MRR SiO₂ [A/min] | Selectivity SiO₂/Si₃N₄ | Selectivity SiO₂/poly-Si |
|---|---|---|---|---|---|---|
| 0.01 | 8 | galactose | 0.25 | 2103 | 100 | 96 |
| 0.01 | 8 | sucralose | 0.25 | 1882 | 125 | 118 |

Combination of Stab0557 as polymer (B) with a polyhydroxy compound (C) as listed in table 8 at pH =8 results in improved selectivities SiO₂/Si₃N₄ and SiO₂/poly-Si, compared to CMP compositions comprising no polymer (B) or Stab 100 as polymer (B) but no polyhydroxy compound (C).

### Measurement of the zeta potential

For several CMP compositions according to the invention as well as for comparison CMP compositions not according to the invention, the zeta potential is measured as a function of the pH value in the pH range from 4 to 10 using a Zetasizer Nano (supplier: Malvern). The measurements start at the pH value which the respective CMP composition has after dilution to a ceria content of 0.1 wt.-% in the presence of 10 mmol/l KCI. For further measurements, the pH of the respective CMP compositions is adjusted by automatic titration with NaOH or HCI.

The concentration of polymers in the tested compositions are as follows:
1. no polymer (comparison composition)
2. 0.002 wt.-% Polyaspartic acid (comparison composition)
3. 0.002 wt.-% Melpers 0045
4. 0.002 wt.-% EPPR312
5. 0.001 wt.- % EPPR312
6. 0.002 wt.-% Stab 100.

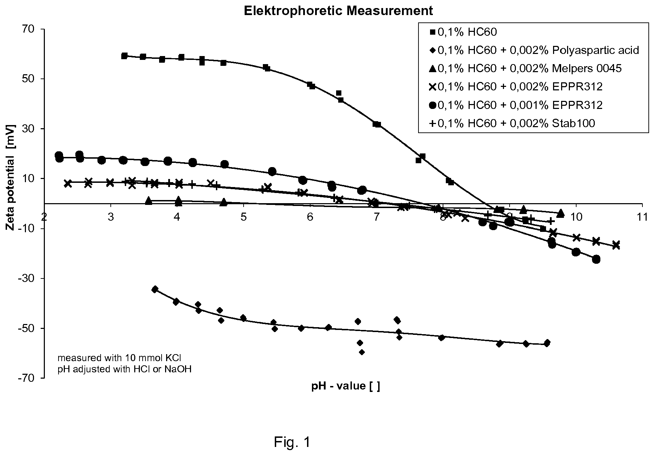

The results (see figure 1) show that polymers (B) used according to the present invention are capable of screening the charge of the ceria containing abrasive particles against electrophoretic excitation. Accordingly, the absolute value of the zeta potential calculated from the electrophoretic mobility is significantly lower than in a CMP composition not comprising any polymer or comprising polyanions without a significant amount of structure units having such screening effect (as it is the case with polyaspartic acid). In the presence of polyaspartic acid, due to the large amount of negative charges of the polyanion, the sign of the zeta potential is negative, and the absolute value of the zeta potential is high.

Despite the low zeta potential of the ceria containing particles in the CMP compositions according to the invention at a pH in the range of from 6 to 10, no coagulation of ceria occurs in this pH range of or at least in a significant subrange of this pH range, due to steric stabilization of the ceria particles.

### Stability test

CMP compositions comprising (A) ceria containing particles were prepared as follows: To 100 ml ultra pure water ceria containing particles (Rhodia HC 60) is added under stirring. The final concentration of ceria containing particles (A) is 0.5 wt.-% The pH is adjusted to with ammonia to the values given in table 9 below.

CMP compositions comprising (A) ceria containing particles and (B) the polymer Stab 100 (see above) were prepared as follows: To 100 ml ultra pure water Stab 100 is added that a concentration of 0.01 wt.-% is reached. Ceria containing particles (Rhodia HC 60) s added under stirring. The final concentration of ceria containing particles (A) is 0.5 wt.-% The pH is adjusted to with ammonia to the values given in table 9 below.

The CMP compositions are stored for three days. Each day, the particle size distribution is measured with Horiba LB 550 V (dynamic light scattering DLS) at different times of storage. The results are given in table 9.

For the CMP composition adjusted to pH 10 without polymer (B), the particle size distribution could not be measured any more after 1 day because the ceria was completely coagulated. In contrast, the CMP composition adjusted to pH 10 containing 0.01 wt.-% of polymer (B) remained stable over three days. The same applies to a CMP composition adjusted to pH 10.8 containing 0.01 wt.-% of polymer (B)

For the CMP composition adjusted to pH 9 without polymer (B), the particle size distribution could not be measured any more at the third day because the ceria was completely coagulated. In contrast, the CMP composition adjusted to pH 9 containing 0.01 wt.-% of polymer (B) remained stable over three days.

**Table 9: D50 values of ceria in CMP compositions with and without polymer (B) at different pH values and storage times : the compositions having a pH outside the range 6.0-10.0 are control compositions.**

| | 0,5 wt.-% ceria | | | 0,5 wt.-% ceria + 0,01 % Stab 100 | | |
|---|---|---|---|---|---|---|
| pH | Day 1 | Day 2 | Day 3 | Day 1 | Day 2 | day 3 |
| 9 | 126 | 151 | settled | 135 | 136 | 128 |
| 10 | settled | | | 133 | 131 | 123 |
| 10.8 | | | | 124 | 119 | 122 |

## Claims

1. Chemical-mechanical polishing (CMP) composition comprising the following constituents:
(A) abrasive particles containing ceria
(B) one or more polymers, wherein each macromolecule of said polymers (B) comprises
(i) one or more anionic functional groups
and
(ii) one or more structure units -(AO)ₐ-R
wherein in each structure unit -(AO)ₐ-R independently from each other structure unit -(AO)ₐ-R
A is CₓH₂ₓ wherein for each A in said structure units -(AO)ₐ-R, x is independently from each other x selected from the range of integers from 2 to 4, wherein x is preferably 2 or 3, further preferably x =2
wherein within each structure unit -(AO)ₐ-R the groups A are the same or different
a is an integer selected from the range of from 5 to 200, preferably 8 to 150, most preferably 20 to 135,
R is hydrogen or a branched or linear alkyl group having 1 to 4 carbon atoms, wherein in said polymer (B) the sum of the molar masses of all structure units (ii) is at least 50 % of the molar mass of said polymer (B)
wherein said composition has a pH in the range of from 6 to 10 and wherein the concentration of said one or more polymers (B) is in a range of from 0.0002 to 0.1 wt.-% based on the total weight of the respective CMP composition.

2. Chemical-mechanical polishing (CMP) composition according to any preceding claim, wherein in the macromolecules of said polymer (B) or of at least one of said polymers (B) said one or more anionic functional groups are selected from the group consisting of the carboxylic group, the sulfonic group, the sulfate group, the phosphoric group and the phosphonic group.

3. Chemical-mechanical polishing (CMP) composition according to any preceding claim, wherein in said polymer (B) or in at least one of said polymers (B)
the molar mass of each of said one or more structure units (ii) -(AO)ₐ-R is 500 g/mol or more, preferably 1000 g/mol or more, more preferably 2000 g/mol or more, most preferably 3000 g/mol or more
and/or
the sum of the molar masses of all of said structure units (ii) -(AO)ₐ-R is 60 % or more, preferably 70 % or more, most preferably 80 % or more of the molar mass of said polymer (B).

4. Chemical-mechanical polishing (CMP) composition according to any preceding claim, wherein said polymer (B) or at least one of said polymers (B) is selected from the group consisting of comb polymers and block copolymers.

5. Chemical-mechanical polishing (CMP) composition according to any preceding claim, wherein said polymer (B) or at least one of said polymers (B) is a comb polymer comprising
(i) a backbone to which one or more anionic functional groups are linked
and
(ii) one or more side chains each comprising a structure unit -(AO)ₐ-R
wherein in said comb polymer the sum of the molar masses of all said structure units (ii) -(AO)ₐ-R is at least 50 % of the molar mass of said comb polymer.

6. Chemical-mechanical polishing (CMP) composition according to any of claims 4 to 5, wherein said comb polymer comprises
- building units each comprising one or more anionic functional groups
and
- side chains each comprising a structure unit (ii) -(AO)ₐ-R wherein
A is CₓH₂ₓ wherein for each A in said structure units -(AO)ₐ-R, x is independently from each other x selected from the range of integers from 2 to 4, wherein x is preferably 2 or 3, further preferably x =2
wherein within each structure unit -(AO)ₐ-R the groups A are the same or different a is an integer selected from the range of from 5 to 200, preferably 8 to 150, most preferably 20 to 135
R is hydrogen or a branched or linear alkyl group having 1 to 4 carbon atoms,
wherein one or more of the building units comprising an anionic functional group are selected from general formulae (7.1), (7.2), (7.3) and (7.4): 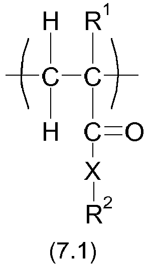
in which
R¹ is H or an unbranched or branched C₁-C₄ alkyl group, CH₂COOH or CH₂CO-X-R²;
R² is PO₃M₂, O-PO₃M₂, (C₆H₄)-PO₃M₂ or (C₆H₄)-OPO₃M₂;
X is NR⁷-(CₙH₂ₙ) or O-(CₙH₂ₙ) with n = 1, 2, 3 or 4, the nitrogen atom or the oxygen atom, respectively, being attached to the CO group;
R⁷ is H, C₁-C₆ alkyl, (CₙH₂ₙ)-OH, (CₙH₂ₙ)-PO₃M₂, (CₙH₂ₙ)-OPO₃M₂, (C₆H₄)-PO₃M₂, (C₆H₄)-OPO₃M₂ or (CₙH₂ₙ)-O-(A²O)_{α} -R⁹; with n = 1, 2, 3 or 4
A² is C_{z}H_{2z} with z = 2, 3, 4 or 5 or is CH₂CH(C₆H₅);
α is an integer from 1 to 350; and
R⁹ is H or an unbranched or branched C₁-C₄ alkyl group;
or X is a chemical bond and R² is OM; 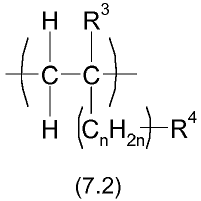
in which
R³ is H or an unbranched or branched C₁-C₄ alkyl group;
n is 0, 1, 2, 3 or 4;
R⁴ is PO₃M₂, or O-PO₃M₂; 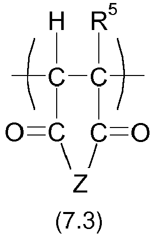
in which
R⁵ is H or an unbranched or branched C₁-C₄ alkyl group;
Z is O or NR⁷; and
R⁷ is H, (CₙH₂ₙ)-OH, (CₙH₂ₙ)-PO₃M₂, (CₙH₂ₙ)-OPO₃M₂, (C₆H₄)-PO₃M₂, or (C₆H₄)-OPO₃M₂, wherein
n is 1, 2, 3 or 4; 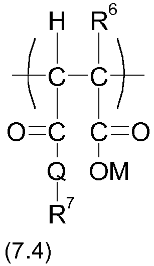
in which
R⁶ is H or an unbranched or branched C₁-C₄ alkyl group;
Q is NR⁷ or O;
R⁷ is H, (CₙH₂ₙ)-OH, (CₙH₂ₙ)-PO₃M₂, (CₙH₂ₙ)-OPO₃M₂, (C₆H₄)-PO₃M₂, (C₆H₄)-OPO₃M₂ or (CₙH₂ₙ)-O-(A²O)_{α} -R⁹,
n is 1, 2, 3 or 4;
A² is CzH_{2z} with z = 2, 3, 4 or 5 or is CH₂CH(C₆H₅);
α is an integer from 1 to 350;
R⁹ is H or an unbranched or branched C₁-C₄ alkyl group;
wherein in formulae (7.1), (7.2), (7.3) and (7.4) each M independently of any other M is H or one cation equivalent
and/or wherein one or more of the side chains comprising a structure unit (ii) -(AO)ₐ-R are selected from general formulae (7.5), (7.6), (7.7) and (7.8): 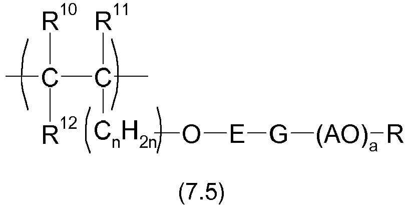 in which
R¹⁰, R¹¹ and R¹² independently of one another are H or an unbranched or branched C₁-C₄ alkyl group;
n is 0, 1, 2, 3, 4 and/or 5;
E is an unbranched or branched C₁-C₆ alkylene group, a cyclohexylene group, CH₂-C₆H₁₀, 1,2-phenylene, 1,3-phenylene or 1,4-phenylene;
G is O, NH or CO-NH; or
E and G together are a chemical bond; 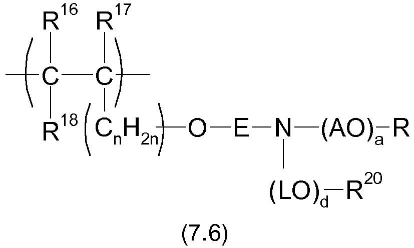
in which
R¹⁶, R¹⁷ and R¹⁸ independently of one another are H or an unbranched or branched C₁-C₄ alkyl group;
n is 0, 1, 2, 3, 4 or 5;
E is an unbranched or branched C₁-C₆ alkylene group, a cyclohexylene group, CH₂-C₆H₁₀, 1,2-phenylene, 1,3-phenylene or 1,4-phenylene or is a chemical bond;
L is C_{z}H_{2z} with z = 2, 3, 4 or 5 or is CH₂-CH(C₆H₅);
d is an integer from 1 to 350;
R²⁰ is H or an unbranched C₁-C₄ alkyl group; 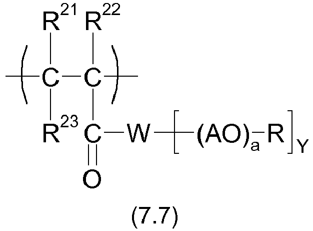
in which
R²¹, R²² and R²³ independently of one another are H or an unbranched or branched C₁-C₄ alkyl group;
W is O, NR²⁵ or N
R²⁵ is H or an unbranched or branched C₁-C₄ alkyl group;
Y is 1, if W = O or NR²⁵, and is 2 ifW= N; 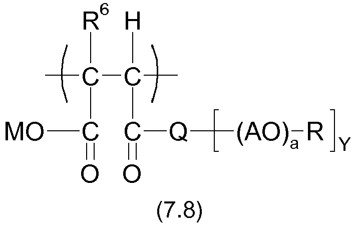
in which
R⁶ is H or an unbranched or branched C₁-C₄ alkyl group;
Q is NR¹⁰, N or O;
R¹⁰ is H or an unbranched or branched C₁-C₄ alkyl group;
Y is 1 if Q = O or NR¹⁰, and is 2 if Q = N.

7. Chemical-mechanical polishing (CMP) composition according to any of claims 4 to 5, wherein said comb polymer (B) is a polycondensate containing
(9.1) at least one building unit comprising an aromatic or heteroaromatic system Ar¹ and a side chain comprising or consisting of a structure unit (ii) - (AO)ₐ-R wherein in each building unit (9.1) independently from each other building unit (9.1)
A is CₓH₂ₓ wherein for each A in said structure units -(AO)ₐ-R, x is independently from each other x selected from the range of integers from 2 to 4, wherein x is preferably 2 or 3, further preferably x =2
wherein within each structure unit -(AO)ₐ-R the groups A are the same or different a is an integer selected from the range of from 5 to 200, preferably 8 to 150, most preferably 20 to 135
R is hydrogen or a branched or linear alkyl group having 1 to 4 carbon atoms, wherein preferably the building units (9.1) are represented by general formula (9.1) 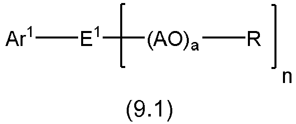 wherein for each building unit of formula (9.1) independently from each other building unit of formula (9.1)
Ar¹ is selected from the group consisting of unsubstituted aromatic or heteroaromatic systems having 5 to 10 carbon atoms in each case
E¹ is selected from the group consisting of N, NH and O, preferably O
n = 2 if E¹ = N and n = 1 if E¹ = NH or O
A, a and R are as defined above
(9.2) at least one building unit comprising an aromatic or heteroaromatic system Ar¹ and a phosphoric group
wherein preferably one or more of the building units (9.2) are represented by general formula (9.2) 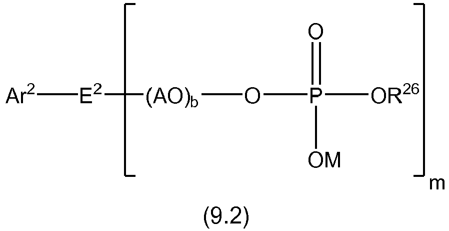 wherein for each building unit of formula (9.2) independently from each other building unit of formula (9.2)
Ar² is selected from the group consisting of unsubstituted aromatic or heteroaromatic system having 5 to 10 carbon atoms in each case
E² is selected from the group consisting of N, NH and O, preferably O
m = 2 if E² = N and m = 1 if E² = NH or O
A is as defined above for building unit (9.1)
b is an integer selected from the range of from 0 to 300, preferably 1 to 5 M independently of any other M is H or one cation equivalent,
R²⁶ is M or Ar¹-O-(AO)ₐ-.
(9.3) at least one building unit comprising an aromatic or heteroaromatic system Ar², wherein building unit (9.3) differs from building unit (9.2) exclusively in that the phosphonic group of the building unit (9.2) is replaced by H in building unit (9.3), and building unit (9.3) is not the same as building unit (9.1)
wherein preferably the building unit (9.3) is represented by general formula (9.3) 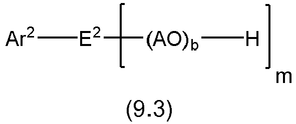 wherein for each building unit of formula (9.3) independently from each other building unit of formula (9.3)
Ar², E², m, A and b are as defined for building unit (9.2)

8. Chemical-mechanical polishing (CMP) composition according to any of claims 1 to 3, wherein said polymer (B) or at least one of said polymers (B) corresponds to the formula (10) 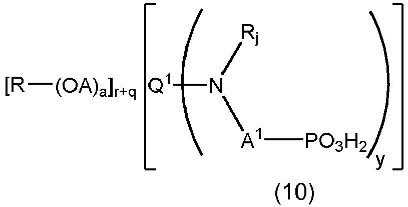 wherein
A is CₓH₂ₓ wherein for each A in said structure units -(AO)ₐ-R, x is independently from each other x selected from the range of integers from 2 to 4, wherein x is preferably 2 or 3, further preferably x =2; wherein within each structure unit -(AO)ₐ-R the groups A are the same or different
- a is an integer selected from the range of from 5 to 200, preferably 8 to 150, most preferably 20 to 135
- R is hydrogen or a branched or linear alkyl group having 1 to 4 carbon atoms,
- Q¹ is a hydrocarbon group comprising 2 to 18 carbon atoms and possibly one or more heteroatoms,
- A¹ is an alkylene group comprising 1 to 5 carbon atoms,
- the Rⱼ groups are independently from each other selected from the group consisting of:
- the A¹-PO₃H₂ group, wherein A¹ has the above-defined meaning,
- the alkyl group comprising 1 to 18 carbon atoms and able to carry -(AO)ₐ-R groups
and
- the group 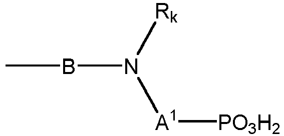 wherein B designates an alkylene group having 2 to 18 carbon atoms,
- r is the number of structure units -(AO)ₐ-R carried by all the Rⱼ groups,
- q is the number of structure units -(AO)ₐ-R carried by Q,
- the sum "r+q" is selected so that in said polymer (B) the sum of the molar masses of all said structure units (ii) -(AO)ₐ-R is at least 50 % of molar mass of said polymer (B) preferably 90 % or more, based on the molar mass of said polymer
- y is an integer in the range of from 1 to 3, wherein when y > 1, the groups 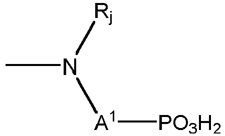 are the same or different
- Q¹, N, and the Rⱼ groups can form together one or more rings, this ring or these rings moreover able to contain one or more other heteroatoms.

9. Chemical mechanical polishing (CMP) composition according to any preceding claim, further comprising
(C) one or more polyhydroxy compounds.

10. Chemical-mechanical polishing (CMP) composition according to any preceding claim, further comprising
(D) one or more pH adjustors.

11. Chemical mechanical polishing (CMP) composition according to any preceding claim, comprising
(A) a total amount of abrasive particles containing ceria in a range of from 0.01 wt.-% to 5 wt.-% based on the total weight of the respective CMP composition,
and/or
(B) a total amount of poylyhdroxy compounds in a range of from 0.001 wt.-% to 2 wt.-% based on the total weight of the respective CMP composition.

12. A process for the manufacture of a semiconductor device comprising chemical mechanical polishing of a substrate in the presence of a chemical mechanical polishing (CMP) composition as defined in any of claims 1 to 11.

13. The process according to claim 12, wherein the substrate comprises
- a surface region or a layer consisting of silicon dioxide
and
- a surface region or a layer consisting of silicon nitride or polycrystalline silicon.

## Patentansprüche

1. Zusammensetzung zum chemisch-mechanischen Polieren (CMP), die folgende Bestandteile umfasst:
(A) Schleifteilchen, die Ceroxid erhalten,
(B) ein oder mehrere Polymere, wobei jedes Makromolekül der Polymere (B)
(i) eine oder mehrere anionische funktionelle Gruppen
und
(ii) ein oder mehrere Struktureinheiten -(AO)ₐ-R,
wobei in jeder Struktureinheit -(AO)ₐ-R unabhängig von jeder anderen Struktureinheit -(AO)ₐ-R
A für CₓH₂ₓ steht, wobei für jedes A in den Struktureinheiten -(AO)ₐ-R x unabhängig von jedem anderen x aus dem Bereich von ganzen Zahlen von 2 bis 4 ausgewählt ist, wobei x vorzugsweise für 2 oder 3 steht, weiter bevorzugt x = 2,
wobei in jeder Struktureinheit -(AO)ₐ-R die Gruppen A gleich oder verschieden sind,
a für eine ganze Zahl aus dem Bereich von 5 bis 200, vorzugsweise 8 bis 150, ganz besonders bevorzugt 20 bis 135, steht,
R für Wasserstoff oder eine verzweigte oder lineare Alkylgruppe mit 1 bis 4 Kohlenstoffatomen steht,
umfasst, wobei in dem Copolymer (B) die Summe der Molmassen aller Struktureinheiten (ii) mindestens 50 % der Molmasse des Polymers (B) beträgt,
wobei die Zusammensetzung einen pH-Wert im Bereich von 6 bis 10 aufweist und wobei die Konzentration des einen oder der mehreren Polymere (B) in einem Bereich von 0,0002 bis 0,1 Gew.-%, bezogen auf das Gesamtgewicht der jeweiligen CMP-Zusammensetzung, liegt.

2. Zusammensetzung zum chemisch-mechanischen Polieren (CMP) nach dem vorhergehenden Anspruch, wobei in den Makromolekülen des Polymers (B) oder mindestens eines der Polymere (B)
die eine oder die mehreren anionischen funktionellen Gruppen aus der Carboxylgruppe, der Sulfonsäuregruppe, der Sulfatgruppen, der Phosphorsäuregruppe und der Phosphonsäuregruppe ausgewählt sind.

3. Zusammensetzung zum chemisch-mechanischen Polieren (CMP) nach einem der vorhergehenden Ansprüche, wobei in dem Polymer (P) oder mindestens einem der Polymere (B)
die Molmasse jede der einen oder mehreren Struktureinheiten (ii) -(AO)ₐ-R 500 g/mol oder mehr, vorzugsweise 1000 g/mol oder mehr, weiter bevorzugt 2000 g/mol oder mehr, ganz besonders bevorzugt 3000 g/mol oder mehr, beträgt und/oder
die Summe der Molmassen aller Struktureinheiten (ii) -(AO)ₐ-R 60 % oder mehr, vorzugsweise 70 % oder mehr, ganz besonders bevorzugt 80 % oder mehr, der Molmasse des Polymers (B) beträgt.

4. Zusammensetzung zum chemisch-mechanischen Polieren (CMP) nach einem der vorhergehenden Ansprüche, wobei das Polymer (B) oder mindestens eines der Polymere (B) aus der Gruppe bestehend aus Kammpolymeren und Blockcopolymeren ausgewählt ist.

5. Zusammensetzung zum chemisch-mechanischen Polieren (CMP) nach einem der vorhergehenden Ansprüche, wobei es sich bei dem Polymer (B) oder mindestens einem der Polymere (B) ein Kammpolymer handelt, das
(i) eine Hauptkette, an die eine oder mehrere anionische funktionelle Gruppen gebunden sind,
und
(ii) eine oder mehrere Seitenketten, die jeweils eine Struktureinheit -(AO)ₐ-R umfassen,
umfasst, wobei in dem Kammpolymer die Summe der Molmassen aller Struktureinheiten (ii) -(AO)ₐ-R mindestens 50 % der Molmasse des Kammpolymers beträgt.

6. Zusammensetzung zum chemisch-mechanischen Polieren (CMP) nach einem der Ansprüche 4 bis 5, wobei das Kammpolymer
- Baueinheiten, die jeweils eine oder mehrere anionische funktionelle Gruppen umfassen,
und
- Seitenketten, die jeweils eine Struktureinheit (ii) -(AO)ₐ-R umfassen, wobei
A für CₓH₂ₓ steht, wobei für jedes A in den Struktureinheiten -(AO)ₐ-R x unabhängig von jedem anderen x aus dem Bereich von ganzen Zahlen von 2 bis 4 ausgewählt ist, wobei x vorzugsweise für 2 oder 3 steht, weiter bevorzugt x = 2,
wobei in jeder Struktureinheit -(AO)ₐ-R die Gruppen A gleich oder verschieden sind,
a für eine ganze Zahl aus dem Bereich von 5 bis 200, vorzugsweise 8 bis 150, ganz besonders bevorzugt 20 bis 135, steht,
R für Wasserstoff oder eine verzweigte oder lineare Alkylgruppe mit 1 bis 4 Kohlenstoffatomen steht,
umfasst, wobei ein oder mehrere der Baueinheiten, die eine anionische funktionelle Gruppe umfassen, aus den allgemeinen Formeln (7.1), (7.2), (7.3) und (7.4) ausgewählt sind: 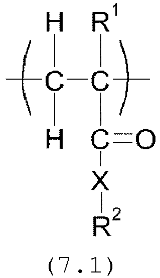 worin
R¹ für H oder eine unverzweigte oder verzweigte C₁-C₄-Alkylgruppe, CH₂COOH oder CH₂CO-X-R² steht;
R² für PO₃M₂, O-PO₃M₂, (C₆H₄) -PO₃M₂ oder (C₆H₄) -OPO₃M₂ steht;
X für NR⁷ - (CₙH₂ₙ) oder O- (CₙH₂ₙ) mit n = 1, 2, 3 oder 4 steht, wobei das Stickstoffatom bzw. das Sauerstoffatom an die CO-Gruppe gebunden ist;
R⁷ für H, C₁-C₆-Alkyl, (CₙH₂ₙ)-OH, (CₙH₂ₙ) -PO₃M₂, (CₙH₂ₙ) -OPO₃M₂, (C₆H₄) -PO₃M₂, (C₆H₄) -OPO₃M₂ oder (CₙH₂ₙ)-O-(A²O)_{α}-R⁹ mit n = 1, 2, 3 oder 4 steht;
A² für C_{z}H_{2z} mit z = 2, 3, 4 oder 5 steht oder für CH₂CH(C₆H₅) steht;
α für eine ganze Zahl von 1 bis 350 steht und
R⁹ für H oder eine unverzweigte oder verzweigte C₁-C₄-Alkylgruppe steht;
oder X für eine chemische Bindung steht und R² für OM steht; 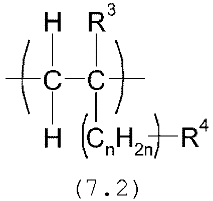 worin
R³ für H oder eine unverzweigte oder verzweigte C₁-C₄-Alkylgruppe steht;
n für 0, 1, 2, 3 oder 4 steht;
R⁴ für PO₃M₂ oder O-PO₃M₂ steht; 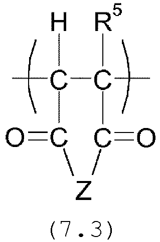
worin
R⁵ für H oder eine unverzweigte oder verzweigte C₁-C₄-Alkylgruppe steht;
Z für O oder NR⁷ steht und
R⁷ für H, (CₙH₂ₙ)-OH, (CₙH₂ₙ)-PO₃M₂, (CₙH₂ₙ)-OPO₃M₂, (C₆H₄)-PO₃M₂ oder (C₆H₄)-OPO₃M₂ steht, wobei
n für 1, 2, 3 oder 4 steht; 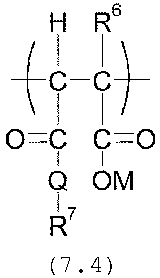
worin
R⁶ für H oder eine unverzweigte oder verzweigte C₁-C₄-Alkylgruppe steht;
Q für NR⁷ oder O steht und
R⁷ für H, (CₙH₂ₙ)-OH, (CₙH₂ₙ)-PO₃M₂, (CₙH₂ₙ)-OPO₃M₂, (C₆H₄) -PO₃M₂, (C₆H₄) -OPO₃M₂ oder (CₙH₂ₙ)-O-(A²O)_{α}-R⁹ steht;
n für 1, 2, 3 oder 4 steht;
A² für C₂H_{2z} mit z = 2, 3, 4 oder 5 steht oder für CH₂CH(C₆H₅) steht;
α für eine ganze Zahl von 1 bis 350 steht;
R⁹ für H oder eine unverzweigte oder verzweigte C₁-C₄-Alkylgruppe steht;
wobei in den Formeln (7.1), (7.2), (7.3) und (7.4) M jeweils unabhängig von jedem anderen M für H oder ein Kationäquivalent steht;
und/oder wobei eine oder mehrere der Seitenketten, die eine Struktureinheit (ii) -(AO)ₐ-R umfassen, aus den allgemeinen Formeln (7.5), (7.6), (7.7) und (7.8) ausgewählt sind: 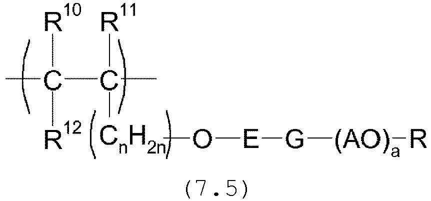 worin
R¹⁰, R¹¹ und R¹² unabhängig voneinander für H oder eine unverzweigte oder verzweigte C₁-C₄-Alkylgruppe stehen;
n für 0, 1, 2, 3, 4 und/oder 5 steht;
E für eine unverzweigte oder verzweigte C₁-C₆-Alkylengruppe, eine Cyclohexylengruppe, CH₂-C₆H₁₀, 1,2-Phenylen, 1,3-Phenylen oder 1,4-Phenylen steht;
G für O, NH oder CO-NH steht; oder
E und G zusammen für eine chemische Bindung stehen; 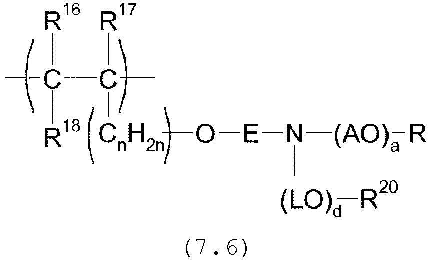
worin
R¹⁶, R¹⁷ und R¹⁸ unabhängig voneinander für H oder eine unverzweigte oder verzweigte C₁-C₄-Alkylgruppe stehen;
n für 0, 1, 2, 3, 4 oder 5 steht;
E für eine unverzweigte oder verzweigte C₁-C₆-Alkylengruppe, eine Cyclohexylengruppe, CH₂-C₆H₁₀, 1,2-Phenylen, 1,3-Phenylen oder 1,4-Phenylen steht oder für eine chemische Bindung steht;
L für C₂H_{2z} mit z = 2, 3, 4 oder 5 steht oder für CH₂-CH(C₆H₅) steht;
d für eine ganze Zahl von 1 bis 350 steht;
R²⁰ für H oder eine unverzweigte C₁-C₄-Alkylgruppe steht; 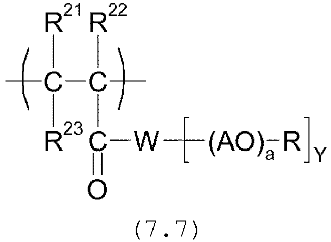
worin
R²¹, R²² und R²³ unabhängig voneinander für H oder eine unverzweigte oder verzweigte C₁-C₄-Alkylgruppe stehen;
W für O, NR²⁵ oder N steht; R²⁵ für H oder eine unverzweigte oder verzweigte C₁-C₄-Alkylgruppe steht;
Y für 1 steht, wenn W = O oder NR²⁵, und für 2 steht, wenn W = N; 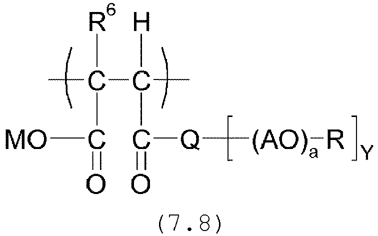
worin
R⁶ für H oder eine unverzweigte oder verzweigte C₁-C₄-Alkylgruppe steht;
Q für NR¹⁰, N oder O steht;
R¹⁰ für H oder eine unverzweigte oder verzweigte C₁-C₄-Alkylgruppe steht;
Y für 1 steht, wenn Q = O oder NR¹⁰, und für 2 steht, wenn Q = N.

7. Zusammensetzung zum chemisch-mechanischen Polieren (CMP) nach einem der Ansprüche 4 bis 5, wobei es sich bei dem Kammpolymer (B) um ein Polykondensat handelt, das
(9.1) mindestens eine Baueinheit, die ein aromatisches oder heteroaromatisches System Ar¹ und eine Seitenkette, die eine Struktureinheit (ii) -(AO)ₐ-R umfasst oder daraus besteht, umfasst,
wobei in jeder Baueinheit (9.1) unabhängig von jeder anderen Baueinheit (9.1)
A für CₓH₂ₓ steht, wobei für jedes A in den Struktureinheiten -AO)ₐ-R x unabhängig von jedem anderen x aus dem Bereich von ganzen Zahlen von 2 bis 4 ausgewählt ist, wobei x vorzugsweise für 2 oder 3 steht, weiter bevorzugt x = 2,
wobei in jeder Struktureinheit -(AO)ₐ-R die Gruppen A gleich oder verschieden sind,
a für eine ganze Zahl aus dem Bereich von 5 bis 200, vorzugsweise 8 bis 150, ganz besonders bevorzugt 20 bis 135, steht,
R für Wasserstoff oder eine verzweigte oder lineare Alkylgruppe mit 1 bis 4 Kohlenstoffatomen steht,
wobei vorzugsweise die Baueinheiten (9.1) durch die allgemeine Formel (9.1) 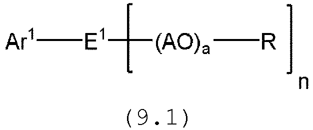 wiedergegeben werden, wobei für jede Baueinheit der Formel (9.1) unabhängig von jeder anderen Baueinheit der Formel (9.1)
Ar¹ aus der Gruppe bestehend aus unsubstituierten aromatischen oder heteroaromatischen Systemen mit jeweils 5 bis 10 Kohlenstoffatomen ausgewählt ist,
E¹ aus der Gruppe bestehend aus N, NH und O, vorzugsweise O, ausgewählt ist,
n = 2, wenn E¹ = N, und n = 1, wenn E¹ = NH oder O,
A, a und R wie oben definiert sind,
(9.2) mindestens eine Baueinheit, die ein aromatisches oder heteroaromatisches System Ar¹ und eine Phosphorsäuregruppe umfasst, wobei vorzugsweise eine oder mehrere der Baueinheiten (9.2) durch die allgemeine Formel (9.2) 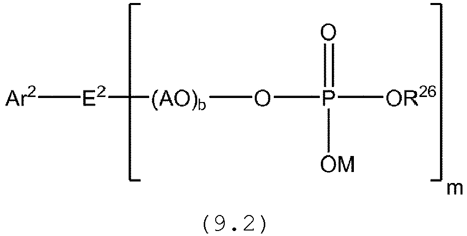 wiedergegeben werden, wobei für jede Baueinheit der Formel (9.2) unabhängig von jeder anderen Baueinheit der Formel (9.2)
Ar² aus der Gruppe bestehend aus unsubstituierten aromatischen oder heteroaromatischen Systemen mit jeweils 5 bis 10 Kohlenstoffatomen ausgewählt ist,
E¹ aus der Gruppe bestehend aus N, NH und O, vorzugsweise O, ausgewählt ist,
m = 2, wenn E² = N, und m = 1, wenn E² = NH oder O,
A wie oben für Baueinheit (9.1) definiert ist,
b für eine ganze Zahl aus dem Bereich von 0 bis 300, vorzugsweise 1 bis 5, steht,
M unabhängig von jedem anderen M für H oder ein Kationäquivalent steht,
R²⁶ für M oder Ar¹-O-(AO)ₐ- steht,
(9.3) mindestens eine Baueinheit, die ein aromatisches oder heteroaromatisches System Ar² umfasst, wobei sich Baueinheit (9.3) nur dadurch von Baueinheit (9.2) unterscheidet, dass die Phosphonsäuregruppe der Baueinheit (9.2) in der Baueinheit (9.3) durch H ersetzt ist, und Baueinheit (9.3) nicht mit Baueinheit (9.1) identisch ist,
wobei vorzugsweise die Baueinheit (9.3) durch die allgemeine Formel (9.3) 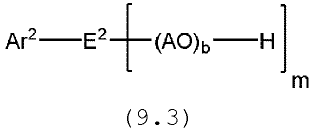 wiedergegeben wird, wobei für jede Baueinheit der Formel (9.3) unabhängig von jeder anderen Baueinheit der Formel (9.3)
Ar², E², m, A und b wie für Baueinheit (9.2) definiert sind,
enthält.

8. Zusammensetzung zum chemisch-mechanischen Polieren (CMP) nach einem der Ansprüche 1 bis 3,
wobei das Polymer (B) oder mindestens eines der Polymere (B) der Formel (10) 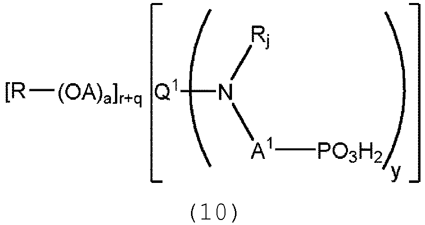 entspricht, wobei
- A für CₓH₂ₓ steht, wobei für jedes A in den Struktureinheiten -(AO)ₐ-R unabhängig von jedem anderen x aus dem Bereich von ganzen Zahlen von 2 bis 4 ausgewählt ist, wobei x vorzugsweise für 2 oder 3 steht, weiter bevorzugt x = 2; wobei in jeder Struktureinheit -(AO)ₐ-R die Gruppen A gleich oder verschieden sind,
- a für eine ganze Zahl aus dem Bereich von 5 bis 200, vorzugsweise 8 bis 150, ganz besonders bevorzugt 20 bis 135, steht,
- R für Wasserstoff oder eine verzweigte oder lineare Alkylgruppe mit 1 bis 4 Kohlenstoffatomen steht,
- Q¹ für eine Kohlenwasserstoffgruppe mit 2 bis 18 Kohlenstoffatomen und gegebenenfalls einem oder mehreren Heteroatomen steht,
- A¹ für eine Alkylengruppe mit 1 bis 5 Kohlenstoffatomen steht,
- die Rⱼ-Gruppen unabhängig voneinander aus der Gruppe bestehend aus:
- der A¹-PO₃H₂-Gruppe, wobei A¹ die oben angegebene Bedeutung hat,
- der Alkylgruppe mit 1 bis 18 Kohlenstoffatomen, die -(AO)ₐ-R-Gruppen tragen kann,
und
- der Gruppe 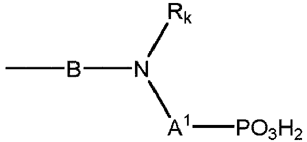 wobei B für eine Alkylengruppe mit 2 bis 18 Kohlenstoffatomen steht,
ausgewählt sind,
- r für die Zahl der von allen der Rⱼ-Gruppen getragenen Struktureinheiten -(AO)ₐ-R steht,
- q für die Zahl der von Q getragenen Struktureinheiten -(AO)ₐ-R steht,
- die Summe "r + q" so gewählt ist, dass in dem Polymer (B) die Summe der Molmassen aller der Struktureinheiten (ii) -(AO)ₐ-R mindestens 50 % der Molmasse des Polymers (B), vorzugsweise 90 % oder mehr, bezogen auf die Molmasse des Polymers, beträgt,
- y für eine ganze Zahl im Bereich von 1 bis 3 steht, wobei im Fall von y > 1 die Gruppen 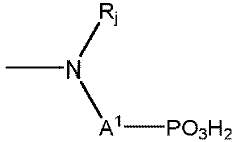 gleich oder verschieden sind,
- Q¹, N und die Rⱼ-Gruppen zusammen einen oder mehrere Ringe bilden können, wobei dieser Ring bzw. diese Ringe ein oder mehrere Heteroatome enthalten kann bzw. können.

9. Zusammensetzung zum chemisch-mechanischen Polieren (CMP) nach einem der vorhergehenden Ansprüche, ferner umfassend
(C) eine oder mehrere Polyhydroxyverbindungen.

10. Zusammensetzung zum chemisch-mechanischen Polieren (CMP) nach einem der vorhergehenden Ansprüche, ferner umfassend
(D) ein oder mehrere Mittel zur Einstellung des pH-Werts.

11. Zusammensetzung zum chemisch-mechanischen Polieren (CMP) nach einem der vorhergehenden Ansprüche, umfassend
(A) eine Gesamtmenge an Schleifteilchen, die Ceroxid enthalten, in einem Bereich von 0,01 Gew.-% bis 5 Gew.-%, bezogen auf das Gesamtgewicht der jeweiligen CMP-Zusammensetzung, und/oder
(B) eine Gesamtmenge an Polyhydroxyverbindungen in einem Bereich von 0,001 Gew.-% bis 2 Gew.-%, bezogen auf das Gewicht der jeweiligen CMP-Zusammensetzung.

12. Verfahren zur Herstellung einer Halbleitervorrichtung, umfassend das chemisch-mechanische Polieren eines Substrats in Gegenwart einer Zusammensetzung zum chemisch-mechanischen Polieren (CMP) gemäß einem der Ansprüche 1 bis 11.

13. Verfahren nach Anspruch 12, wobei das Substrat
- einen Oberflächenbereich oder eine Schicht aus Siliciumdioxid
und
- einen Oberflächenbereich oder eine Schicht aus Siliciumnitrid oder polykristallinem Silicium
umfasst.

## Revendications

1. Composition de polissage chimico-mécanique (CMP) comprenant les constituants suivants :
(A) des particules abrasives contenant de l'oxyde de cérium
(B) un ou plusieurs polymères, dans lesquels chaque macromolécule desdits polymères (B) comprend
(i) un ou plusieurs groupes fonctionnels anioniques et
(ii) un ou plusieurs motifs structuraux -(AO)ₐ-R dans laquelle, dans chaque motif structural -(AO)ₐ-R, indépendamment de chaque autre motif structural -(AO)ₐ-R A est CₓH₂ₓ dans lequel, pour chaque A dans lesdits motifs structuraux -(AO)ₐ-R, x est, indépendamment de chaque autre x, choisi dans la plage d'entiers de 2 à 4, dans lequel x est de préférence 2 ou 3, plus préférablement x = 2
dans laquelle, dans chaque motif structural -(AO)ₐ-R, les groupes A sont identiques ou différents a est un entier choisi dans la plage de 5 à 200, de préférence 8 à 150, de manière préférée entre toutes 20 à 135,
R est hydrogène ou un groupe alkyle ramifié ou linéaire ayant 1 à 4 atomes de carbone,
dans laquelle, dans ledit polymère (B), la somme des masses molaires de tous les motifs structuraux (ii) est au moins 50 % de la masse molaire dudit polymère (B) dans laquelle ladite composition a un pH dans la plage de 6 à 10 et dans laquelle la concentration desdits un ou plusieurs polymères (B) est dans une plage de 0,0002 à 0,1 % en poids sur la base du poids total de la composition CMP respective.

2. Composition de polissage chimico-mécanique (CMP) selon l'une quelconque des revendications précédentes, dans laquelle, dans les macromolécules dudit polymère (B) ou d'au moins l'un desdits polymères (B) lesdits un ou plusieurs groupes fonctionnels anioniques sont choisis dans le groupe constitué du groupe carboxylique, du groupe sulfonique, du groupe sulfate, du groupe phosphorique et du groupe phosphonique.

3. Composition de polissage chimico-mécanique (CMP) selon l'une quelconque des revendications précédentes, dans laquelle, dans ledit polymère (B) ou dans au moins l'un desdits polymères (B)
la masse molaire de chacun desdits un ou plusieurs motifs structuraux (ii)-(AO)ₐ-R est de 500 g/mol ou plus, de préférence 1000 g/mol ou plus, plus préférablement 2000 g/mol ou plus, de manière préférée entre toutes 3000 g/mol ou plus
et/ou
la somme des masses molaires de l'ensemble desdits motifs structuraux (ii)-(AO)ₐ-R est 60 % ou plus, de préférence 70 % ou plus, de manière préférée entre toutes 80 % ou plus de la masse molaire dudit polymère (B) .

4. Composition de polissage chimico-mécanique (CMP) selon l'une quelconque des revendications précédentes, dans laquelle ledit polymère (B) ou au moins l'un desdits polymères (B) est choisi dans le groupe constitué de polymères à structure en peigne et de copolymères séquencés.

5. Composition de polissage chimico-mécanique (CMP) selon l'une quelconque des revendications précédentes, dans laquelle ledit polymère (B) ou au moins l'un desdits polymères (B) est un polymère à structure en peigne comprenant
(i) un squelette auquel un ou plusieurs groupes fonctionnels anioniques sont liés et
(ii) une ou plusieurs chaînes latérales comprenant chacune un motif structural -(AO)ₐ-R
dans laquelle, dans ledit polymère à structure en peigne la somme des masses molaires de tous lesdits motifs structuraux (ii)-(AO)ₐ-R est au moins 50 % de la masse molaire dudit polymère à structure en peigne.

6. Composition de polissage chimico-mécanique (CMP) selon l'une quelconque des revendications 4 à 5, dans laquelle ledit polymère à structure en peigne comprend
- des motifs de construction comprenant chacun un ou plusieurs groupes fonctionnels anioniques
et
- des chaînes latérales comprenant chacune un motif structural (ii)-(AO)ₐ-R dans lequel
A est CₓH₂ₓ dans lequel, pour chaque A dans lesdits motifs structuraux -(AO)ₐ-R, x est, indépendamment de chaque autre x, choisi dans la plage d'entiers de 2 à 4, dans lequel x est de préférence 2 ou 3, plus préférablement x = 2
dans lequel, dans chaque motif structural -(AO)ₐ-R, les groupes A sont identiques ou différents
a est un entier choisi dans la plage de 5 à 200, de préférence 8 à 150, de manière préférée entre toutes 20 à 135
R est hydrogène ou un groupe alkyle ramifié ou linéaire ayant 1 à 4 atomes de carbone,
dans laquelle un ou plusieurs des motifs de construction comprenant un groupe fonctionnel anionique sont choisis parmi les formules générales (7.1), (7.2), (7.3) et (7.4) : 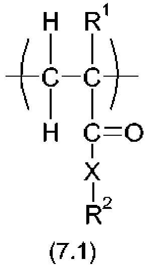 dans laquelle
R¹ est H ou un groupe alkyle en C₁-C₄ non ramifié ou ramifié, CH₂COOH ou CH₂CO-X-R² ;
R² est PO₃M₂, O-PO₃M₂, (C₆H₄) -PO₃M₂ ou (C₆H₄) -OPO₃M₂ ;
X est NR⁷-(CₙH₂ₙ) ou O-(CₙH₂ₙ) avec n = 1, 2, 3 ou 4, l'atome d'azote ou l'atome d'oxygène, respectivement, étant lié au groupe CO ;
R⁷ est H, alkyle en C₁₋C₆, (CₙH₂ₙ)-OH, (CₙH₂ₙ)-PO₃M₂, (CₙH₂ₙ)-OPO₃M₂, (C₆H₄)-PO₃M₂, (C₆H₄)-OPO₃M₂ ou (CₙH₂ₙ)-O-(A²O)_{α}-R⁹ ; avec n = 1, 2, 3 ou 4
A² est C₂H_{2z} avec z = 2, 3, 4 ou 5 ou est CH₂CH(C₆H₅) ;
α est un entier de 1 à 350 ; et
R⁹ est H ou un groupe alkyle en C₁-C₄ non ramifié ou ramifié ;
ou X est une liaison chimique et R² est OM ; 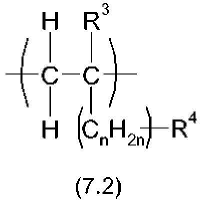
dans laquelle
R³ est H ou un groupe alkyle en C₁-C₄ non ramifié ou ramifié ;
n est 0, 1, 2, 3 ou 4 ;
R⁴ est OPO₃M₂, ou O-OPO₃M₂ ; 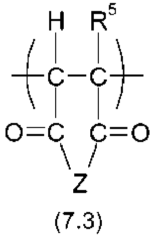
dans laquelle
R⁵ est H ou un groupe alkyle en C₁-C₄ non ramifié ou ramifié ;
Z est O ou NR⁷ ; et
R⁷ est H, (CₙH₂ₙ)-OH, (CₙH₂ₙ)-OPO₃M₂, (CₙH₂ₙ)-OPO₃M₂, (C₆H₄)- PO₃M₂ ou (C₆H₄)-OPO₃M₂, où
n est 1, 2, 3 ou 4 ; 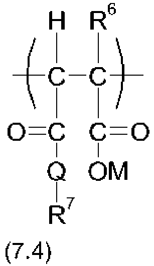
dans laquelle
R⁶ est H ou un groupe alkyle en C₁-C₄ non ramifié ou ramifié ;
Q est NR⁷ ou O ;
R⁷ est H, (CₙH₂ₙ)-OH, (CₙH₂ₙ)-PO₃M₂, (CₙH₂ₙ)-OPO₃M₂, (C₆H₄)-PO₃M₂, (C₆H₄)-OPO₃M₂ ou (CₙH₂ₙ)-O-(A²O)_{α}-R⁹,
n est 1, 2, 3 ou 4 ;
A² est C₂H_{2z} avec z = 2, 3, 4 ou 5 ou est CH₂CH(C₆H₅) ;
α est un entier de 1 à 350 ;
R⁹ est H ou un groupe alkyle en C₁-C₄ non ramifié ou ramifié ;
dans laquelle, dans les formules (7.1), (7.2), (7.3) et (7.4) chaque M, indépendamment de chaque autre M, est H ou un cation équivalent
et/ou dans laquelle une ou plusieurs des chaînes latérales comprenant un motif structural (ii) -(AO)ₐ-R sont choisies parmi les formules générales (7.5), (7.6), (7.7) et (7.8) : 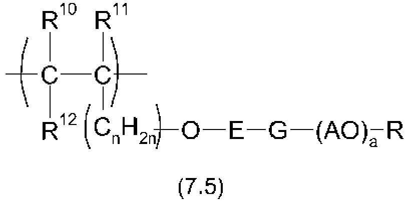
dans laquelle
R¹⁰, R¹¹ et R¹², indépendamment les uns des autres, sont H ou un groupe alkyle en C₁-C₄ non ramifié ou ramifié ; n est 0, 1, 2, 3, 4 et/ou 5 ;
E est un groupe alkylène en C₁-C₆ non ramifié ou ramifié, un groupe cyclohexylène, CH₂-C₆H₁₀, 1,2-phénylène, 1,3-phénylène ou 1,4-phénylène ;
G est O, NH ou CO-NH ; ou
E et G sont conjointement une liaison chimique ; 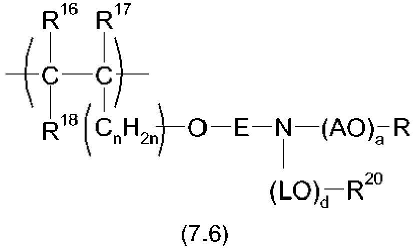
dans laquelle
R¹⁶, R¹⁷ et R¹⁸, indépendamment les uns des autres, sont H ou un groupe alkyle en C₁-C₄ non ramifié ou ramifié ;
n est 0, 1, 2, 3, 4 ou 5 ;
E est un groupe alkylène en C₁-C₆ non ramifié ou ramifié, un groupe cyclohexylène, CH₂-C₆H₁₀, 1,2-phénylène, 1,3-phénylène ou 1,4-phénylène ou est une liaison chimique ;
L est C₂H_{2z} avec z = 2, 3, 4 ou 5 ou est CH₂-CH (C₆H₅) ; d est un entier de 1 à 350 ;
R²⁰ est H ou un groupe alkyle en C₁-C₄ non ramifié ; 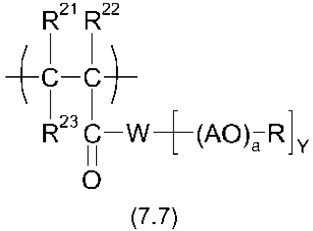
dans laquelle
R²¹, R²² et R²³ indépendamment, les uns des autres, sont H ou un groupe alkyle en C₁-C₄ non ramifié ou ramifié ;
W est O, NR²⁵ ou N
R²⁵ est H ou un groupe alkyle en C₁-C₄ non ramifié ou ramifié ;
Y est 1, si W = O ou NR²⁵, et est 2 si W = N ; 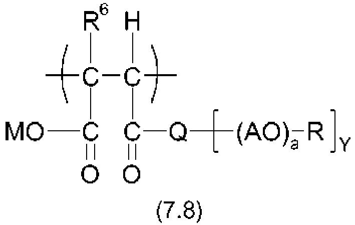
dans laquelle
R⁶ est H ou un groupe alkyle en C₁-C₄ non ramifié ou ramifié ;
Q est NR¹⁰, N ou O ;
R¹⁰ est H ou un groupe alkyle en C₁-C₄ non ramifié ou ramifié ;
Y est 1 si Q = O ou NR¹⁰, et est 2 si Q = N.

7. Composition de polissage chimico-mécanique (CMP) selon l'une quelconque des revendications 4 à 5, dans laquelle ledit polymère à structure en peigne (B) est un polycondensat contenant
(9.1) au moins un motif de construction comprenant un système aromatique ou hétéroaromatique Ar¹ et une chaîne latérale comprenant ou constituée d'un motif structural (ii) -(AO)ₐ-R dans lequel, dans chaque motif de construction (9.1), indépendamment de chaque autre motif de construction (9.1)
A est CₓH₂ₓ dans lequel, pour chaque A dans lesdits motifs structuraux -(AO)ₐ-R, x est, indépendamment de chaque autre x, choisi dans la plage d'entiers de 2 à 4, dans lequel x est de préférence 2 ou 3, plus préférablement x = 2
dans lequel, dans chaque motif structural -(AO)ₐ-R, les groupes A sont identiques ou différents
a est un entier choisi dans la plage de 5 à 200, de préférence 8 à 150, de manière préférée entre toutes 20 à 135
R est hydrogène ou un groupe alkyle ramifié ou linéaire ayant 1 à 4 atomes de carbone,
dans laquelle, de préférence, les motifs de construction (9.1) sont représentés par la formule générale (9.1) 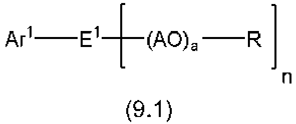 dans laquelle, pour chaque motif de construction de formule (9.1), indépendamment de chaque autre motif de construction de formule (9.1)
Ar¹ est choisi dans le groupe constitué de systèmes aromatiques ou hétéroaromatiques non substitués ayant 5 à 10 atomes de carbone dans chaque cas
E¹ est choisi dans le groupe constitué de N, NH et O, de préférence O
n = 2 si E¹ = N et n = 1 si E¹ = NH ou O A, a et R sont tels que définis ci-dessus
(9.2) au moins un motif de construction comprenant un système aromatique ou hétéroaromatique Ar¹ et un groupe phosphorique
dans laquelle, de préférence, un ou plusieurs des motifs de construction (9.2) sont représentés par la formule générale (9.2) 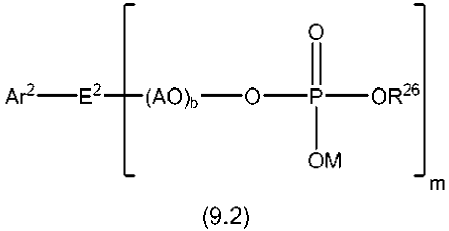 dans laquelle, pour chaque motif de construction de formule (9.2) indépendamment de chaque autre motif de construction de formule (9.2)
Ar² est choisi dans le groupe constitué d'un système aromatique ou hétéroaromatique non substitué ayant 5 à 10 atomes de carbone dans chaque cas
E² est choisi dans le groupe constitué de N, NH et O, de préférence O
m = 2 si E² = N et m = 1 si E² = NH ou O
A est tel que défini ci-dessus pour le motif de construction (9.1)
b est un entier choisi dans la plage de 0 à 300, de préférence 1 à 5
M, indépendamment de chaque autre M, est H ou un cation équivalent,
R²⁶ est M ou Ar¹-O-(AO)ₐ-
(9.3) au moins un motif de construction comprenant un système aromatique ou hétéroaromatique Ar², dans laquelle le motif de construction (9.3) diffère du motif de construction (9.2) exclusivement en ce que le groupe phosphonique du motif de construction (9.2) est remplacé par H dans le motif de construction (9.3), et le motif de construction (9.3) n'est pas le même que le motif de construction (9.1)
dans laquelle, de préférence, le motif de construction (9.3) est représenté par la formule générale (9.3) 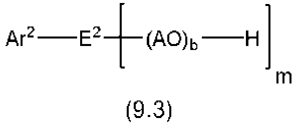 dans laquelle, pour chaque motif de construction de formule (9.3), indépendamment de chaque autre motif de construction de formule (9.3)
Ar², E², m, A et b sont tels que définis pour le motif de construction (9.2).

8. Composition de polissage chimico-mécanique (CMP) selon l'une quelconque des revendications 1 à 3, dans laquelle ledit polymère (B) ou au moins l'un desdits polymères (B) correspond à la formule (10) 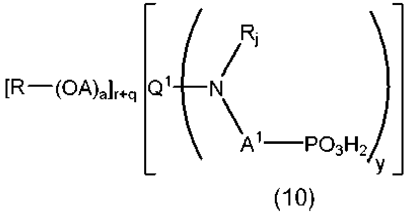 dans laquelle
A est CₓH₂ₓ dans lequel, pour chaque A dans lesdits motifs structuraux -(AO)ₐ-R, x est, indépendamment de chaque autre x, choisi dans la plage d'entiers de 2 à 4, dans lequel x est de préférence 2 ou 3, plus préférablement x = 2 ; dans lequel, dans chaque motif structural -(AO)ₐ-R, les groupes A sont identiques ou différents
- a est un entier choisi dans la plage de 5 à 200, de préférence 8 à 150, de manière préférée entre toutes 20 à 135
- R est hydrogène ou un groupe alkyle ramifié ou linéaire ayant 1 à 4 atomes de carbone,
- Q¹ est un groupe hydrocarboné comprenant 2 à 18 atomes de carbone et éventuellement un ou plusieurs hétéroatomes,
- A¹ est un groupe alkylène comprenant 1 à 5 atomes de carbone,
- les groupes Rⱼ sont, indépendamment les uns des autres, choisis dans le groupe constitué de :
- le groupe A¹-PO₃H₂, dans lequel A¹ a la signification définie ci-dessus,
- le groupe alkyle comprenant 1 à 18 atomes de carbone et pouvant comporter des groupes -(AO)ₐ-R et
- le groupe 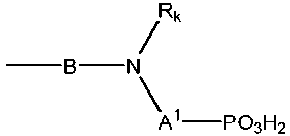 dans lequel B désigne un groupe alkylène ayant 2 à 18 atomes de carbone,
- r est le nombre de motifs structuraux -(AO)ₐ-R portés par tous les groupes Rⱼ,
- q est le nombre de motifs structuraux -(AO)ₐ-R portés par Q,
- la somme "r+q" est choisie de sorte que, dans ledit polymère (B), la somme des masses molaires de tous lesdits motifs structuraux (ii) -(AO)ₐ-R est au moins 50 % de la masse molaire dudit polymère (B), de préférence 90 % ou plus, sur la base de la masse molaire dudit polymère
- y est un entier dans la plage de 1 à 3, dans laquelle, lorsque y > 1, les groupes 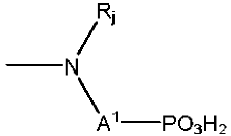 sont identiques ou différents
- Q¹, N, et les groupes Rⱼ peuvent former conjointement un ou plusieurs cycles, ce cycle ou ces cycles pouvant en outre contenir un ou plusieurs autres hétéroatomes.

9. Composition de polissage chimico-mécanique (CMP) selon l'une quelconque des revendications précédentes, comprenant en outre
(C) un ou plusieurs composés polyhydroxy.

10. Composition de polissage chimico-mécanique (CMP) selon l'une quelconque des revendications précédentes, comprenant en outre
(D) un ou plusieurs agents d'ajustement du pH.

11. Composition de polissage chimico-mécanique (CMP) selon l'une quelconque des revendications précédentes, comprenant
(A) une quantité totale de particules abrasives contenant de l'oxyde de cérium dans une plage de 0,01 % en poids à 5 % en poids sur la base du poids total de la composition CMP respective,
et/ou
(B) une quantité totale de composés polyhydroxy dans une plage de 0,001 % en poids à 2 % en poids sur la base du poids total de la composition CMP respective.

12. Procédé de fabrication d'un dispositif à semiconducteur comprenant le polissage chimico-mécanique d'un substrat en présence d'une composition de polissage chimico-mécanique (CMP) telle que définie dans l'une quelconque des revendications 1 à 11.

13. Procédé selon la revendication 12, dans lequel le substrat comprend
- une région de surface ou une couche constituée de dioxyde de silicium
et
- une région de surface ou une couche constituée de nitrure de silicium ou de silicium polycristallin.
